# EUROPEAN PATENT APPLICATION

(11) **EP 2 378 361 A1**
(43) Date of publication of application: **19.10.2011**
(21) Application number: 11159764.7
(22) Date of filing: 25.03.2011
(51) Int. Cl.: G03F 7/09, G03F 7/32, B41C 1/10

(54) **Method for preparing lithographic printing plate**

(30) Priority: 26.03.2010 JP 2010073871
(71) Applicant: Fujifilm Corporation, Minato-ku Tokyo (JP)
(72) Inventor: Arimura, Keisuke, Haibara-gun, Shizuoka (JP)
(74) Representative: HOFFMANN EITLE

(57) **Abstract**

To provide a method of preparing a lithographic printing plate which fulfils an excellent processing stability in that the occurrence of development scum is low and a developing property is well maintained at the time of running and can prepare a lithographic printing plate excellent in printing durability even in plate making of a lithographic printing plate including a development processing step which contains a step of removing a protective layer and the unexposed area of a photosensitive layer at the same time and does not contain a water washing step, the invention is directed to a method of preparing a lithographic printing plate which contains after exposing with laser a lithographic printing plate precursor comprising (i) a hydrophilic support, (ii) a photosensitive layer containing (A) a polymerization initiator, (B) a polymerizable compound, (C) a sensitizing dye and (D) a binder polymer and (iii) a protective layer containing (E) a polymer which contains a repeating unit having a specific structure in this order, a step of removing the protective layer and an unexposed area of the photosensitive layer at the same time in the presence of a developer containing a surfactant and does not contain a water washing step.

## Description

### FIELD OF THE INVENTION

The present invention relates to a method of preparing a lithographic printing plate.

### BACKGROUND OF THE INVENTION

In general, a lithographic printing plate is composed of an oleophilic image area accepting ink and a hydrophilic non-image area accepting dampening water in the process of printing. Lithographic printing is a printing method which comprises rendering the oleophilic image area of the lithographic printing plate to an ink-receptive area and the hydrophilic non-image area thereof to a dampening water-receptive area (ink unreceptive area), thereby making a difference in adherence of ink on the surface of the lithographic printing plate, and depositing the ink only on the image area by utilizing the nature of water and printing ink to repel with each other, and then transferring the ink to a printing material, for example, paper.

In order to prepare the lithographic printing plate, a lithographic printing plate precursor (PS plate) comprising a hydrophilic support having provided thereon an oleophilic photosensitive resin layer (also referred to as a photosensitive layer or an image-recording layer) has heretofore been broadly used. Ordinarily, the lithographic printing plate is obtained by conducting plate making according to a method of exposing the lithographic printing plate precursor through an original, for example, a lith film, and then removing the unnecessary portion of the image-recording layer by dissolving with an alkaline developer or an organic solvent thereby revealing the hydrophilic surface of support to form the non-image area while leaving the image-recording layer in the portion for forming the image area.

In contrast, in recent years, digitalized technique of electronically processing, accumulating and outputting image information using a computer has been popularized, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film. Thus, it is one of important technical subjects to obtain a lithographic printing plate precursor adaptable to the technique described above.

In the hitherto known plate making process of lithographic printing plate precursor, after exposure, the step of removing the unnecessary portion of the image-recording layer by dissolving, for example, with a strongly alkaline developer is required. However, in view of the environment and safety, to realize a processing with a developer closer to a neutral range and to decrease an amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

As described above, the decrease in alkali concentration of developer and the simplification of processing step have been further strongly required from both aspects of the consideration for global environment and the adaptation for space saving and low running cost. However, since hitherto known development processing comprises three steps of developing with an aqueous strong alkali solution having pH of 11 or more, washing of the alkali agent with a water-washing bath and then treating with a gum solution mainly comprising a hydrophilic resin as described above, an automatic developing machine per se requires a large space and problems of the environment and running cost, for example, disposal of the development waste liquid, water-washing waste liquid and gum waste liquid still remain.

In response to the above situation, for instance, a method of preparing a lithographic printing plate including a developing method of processing with a developer having pH from 8.5 to 11.5 and a dielectric constant from 3 to 30 mS/cm and containing an alkali metal carbonate and an alkali metal hydrogen carbonate is proposed in JP-A-11-65126 (the term "JP-A" as used herein means an "unexamined published Japanese patent application"). However, since the method is required a water washing step and a treatment step with a gum solution, it does not resolve the problems of the environment and running cost.

Also, a method of preparing a lithographic printing plate including processing with a processing solution having pH from 11.9 to 12.1 and containing a water-soluble polymer compound is described in EP-A-1868036. However, since the lithographic printing plate obtained by the processing is left in the state that the alkali of pH 12 adheres on the surface thereof, a problem in view of safety of an operator arises and also another problem occurs in that with the lapse of long time after the preparation of the lithographic printing plate until the initiation of printing, the image area gradually dissolves to result in deterioration in printing durability or ink-receptive property.

In JP-T-2007-538279 (the term "JP-T" as used herein means a published Japanese translation of a PCT patent application), a method of preparing a lithographic printing plate including processing with a processing solution having pH of 3 to 9 and containing a water-soluble polymer compound is described. However, since the processing solution does not contain a basic component, it is necessary to enable development by making a polymer used in the photosensitive layer hydrophilic and thus, a problem occurs in that printing durability severely degrades.

On the other hand, a method of preparing a lithographic printing plate including development processing using a developer other than a strongly alkaline developer to remove a protective layer and the unexposed area of a photosensitive layer in only one developing tank (by one bath) without accompanying a water washing step is known (see, for example, WO 2007/057336). However, the method has problems in that the components of the photosensitive layer and the components of the protective layer which are unable to be dissolved accumulate on the bottom of a developing bath and in that the viscosity of a developer increases so that the circulation of a development machine can not be sufficiently conducted, in particular, when an automatic development processor is used.

Further, in JP-A-2007-114738, a plate making method of a lithographic printing plate including processing a lithographic printing plate precursor containing a water-soluble poly(meth)acrylate in its protective layer with a developer having pH from 11.0 to 12.7 is described. However, the method is intended to prevent adhesion between the protective layer and an interleaf and there is no description on processing stability in a low alkali developer.

### SUMMARY OF THE INVENTION

An object of the present invention is to provide a method of preparing a lithographic printing plate which fulfils an excellent processing stability in that the occurrence of development scum is low and a developing property is well maintained at the time of running and can prepare a lithographic printing plate excellent in printing durability even in plate making of a lithographic printing plate including a development processing step which contains a step of removing a protective layer and the unexposed area of a photosensitive layer at the same time and does not contain a water washing step.

As a result of the intensive investigations for solving the above-described problem, the inventor has found that the development scum can be reduced while achieving the excellent developing property in one bath development by incorporating a specific polymer into a protective layer of a lithographic printing plate precursor to complete the invention.

Specifically, the above-described problem can be solved by the means described below.
<1> A method of preparing a lithographic printing plate which contains after exposing with laser a lithographic printing plate precursor comprising (i) a hydrophilic support, (ii) a photosensitive layer containing (A) a polymerization initiator, (B) a polymerizable compound, (C) a sensitizing dye and (D) a binder polymer and (iii) a protective layer containing (E) a polymer which contains a repeating unit represented by formula (I) shown below and in which a ratio of a repeating unit having a hydroxy group to total repeating units is 70% by mole or less in this order, a step of removing the protective layer and an unexposed area of the photosensitive layer at the same time in the presence of a developer containing a surfactant and does not contain a water washing step: 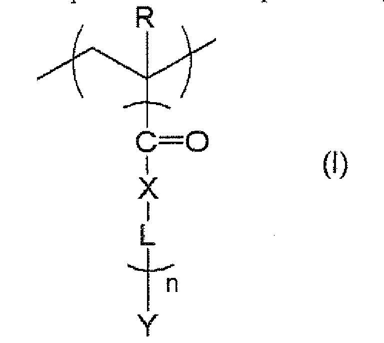 in formula (I), R represents a hydrogen atom or an alkyl group which may have a substituent, X represents an oxygen atom, a sulfur atom or -NR₁-, R₁ represents a hydrogen atom or an alkyl group which may have a substituent, L represents a single bond or a connecting group, Y represents -SO₃M, -PO₃M₂ or -COOM, M each independently represents a hydrogen atom, an alkali metal atom or an onium group, and n represents an integer of 0 or more.
<2> The method of preparing a lithographic printing plate as described in <1>, wherein pH of the developer is from 2.0 to 10.9.
<3> The method of preparing a lithographic printing plate as described in <1> or <2>, wherein the developer contains a pH buffer agent.
<4> The method of preparing a lithographic printing plate as described in <3>, wherein the pH buffer agent contains a carbonate and a hydrogen carbonate.
<5> The method of preparing a lithographic printing plate as described in <3>, wherein the pH buffer agent contains a water-soluble organic amine compound and an ion of the amine compound.
<6> The method of preparing a lithographic printing plate as described in any one of <1> to <5>, wherein the developer contains a water-soluble polymer compound.
<7> The method of preparing a lithographic printing plate as described in any one of <1> to <6>, wherein Y in formula (I) is -SO₃M.
<8> The method of preparing a lithographic printing plate as described in any one of <1> to <7>, the protective layer further contains a water-soluble polymer compound which is different from the polymer which contains a repeating unit represented by formula (I).
<9> The method of preparing a lithographic printing plate as described in <8>, wherein the water-soluble polymer compound is polyvinyl alcohol.
<10> The method of preparing a lithographic printing plate as described in <9>, wherein the polyvinyl alcohol comprises at least two polyvinyl alcohols having saponification degrees different from each other.
<11> The method of preparing a lithographic printing plate as described in any one of <1> to <10>, the protective layer further contains an inorganic stratiform compound.

The method of preparing a lithographic printing plate according to the present invention fulfils an excellent processing stability in that the occurrence of development scum is low and a developing property is well maintained at the time of running and can prepare a lithographic printing plate excellent in printing durability even in plate making of a lithographic printing plate including a development processing step which contains a step of removing a protective layer and the unexposed area of a photosensitive layer at the same time and does not contain a water washing step.

Specifically, according to method of preparing a lithographic printing plate of the invention, due to the incorporation of a specific polymer into a protective layer of a lithographic printing plate precursor, the solubility and dispersibility of the protective layer in a developer increases so that the development scum hardly occurs in the development processing of the lithographic printing plate precursor.

### BRIEF DESCRIPTION OF THE DRAWINGS

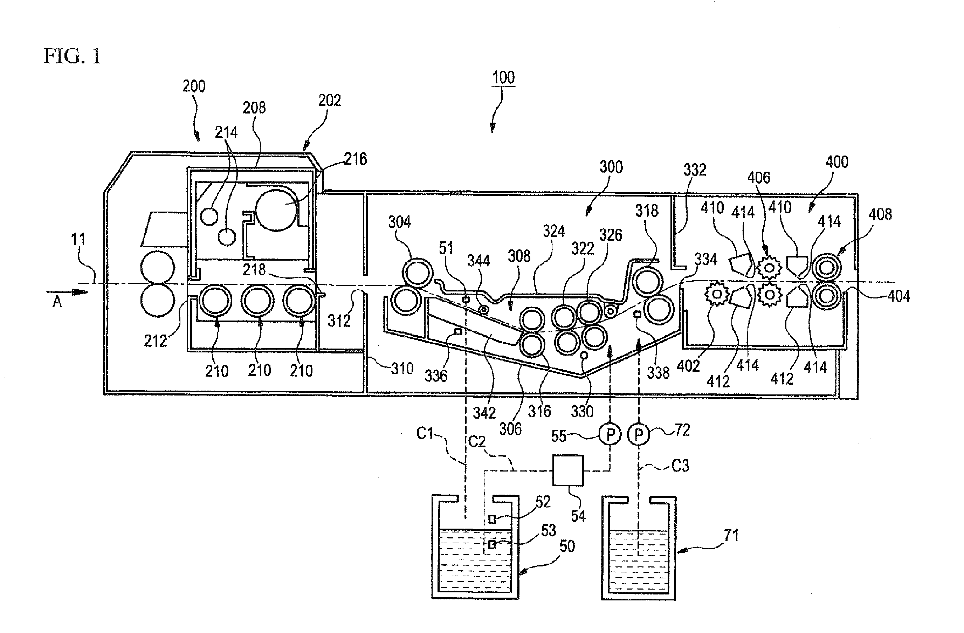

Fig. 1 is a perspective side view schematically showing an internal structure of an automatic development processor used in the method of preparing a lithographic printing plate according to the invention.

### [Description of reference numerals and signs]

- 11:: Transporting path of lithographic printing plate precursor
- 100:: Automatic development processor
- 200:: Pre-heating unit
- 300:: Developing unit
- 400:: Drying unit
- 202:: Machine casing
- 208:: Heating chamber
- 210:: Skewer roller
- 212:: Transporting inlet
- 214:: Heater
- 216:: Circulation fan
- 218:: Transporting outlet
- 304:: Insertion roller pair
- 306:: Processing tank
- 308:: Developing tank (filled with developer)
- 310:: Outer panel
- 312:: Slit type insertion slot
- 316:: Submerged roller pair
- 318:: Carrying-out roller pair
- 322:: Brush roller pair
- 324:: Shielding cover
- 326:: Brush roller pair
- 330:: Spray pipe

- 332:: Partition board
- 334:: Slit type path-through slot
- 336:: Liquid temperature sensor
- 338:: Liquid level meter
- 342:: Guide member
- 344:: Guide roller
- 402:: Support roller
- 404:: Discharge slot
- 406:: Transport roller pair
- 408:: Transport roller pair
- 410:: Duct
- 412:: Duct
- 414:: Slit hole
- 50:: External tank (storing developer)
- 51:: Overflow aperture
- 52:: Upper limit liquid level meter
- 53:: Lower limit liquid level meter
- 54:: Filter unit
- 55:: Developer supply pump
- C1:: First circulation pipeline
- C2:: Second circulation pipeline
- 71:: Water tank for replenishment (storing water)
- 72:: Water-replenishing pump
- C3:: Third circulation pipeline

### DETAILED DESCRIPTION OF THE INVENTION

The present invention will be described in detail hereinafter.

First, a lithographic printing plate precursor for use in the method of preparing a lithographic printing plate according to the invention is described below.

### [Lithographic printing plate precursor]

The lithographic printing plate precursor for use in the method of preparing a lithographic printing plate according to the invention comprises (i) a hydrophilic support, (ii) a photosensitive layer and (iii) a protective layer in this order.

The photosensitive layer contains (A) a polymerization initiator, (B) a polymerizable compound, (C) a sensitizing dye and (D) a binder polymer. Also, the photosensitive layer may further contain other components, if desired.

### <Photosensitive layer>

### (A) Polymerization initiator

As the polymerization initiator for use in the invention, polymerization initiators known to those skilled in the art can be used without limitation. The polymerization initiator includes, for example, a hexaarylbisimidazole compound, a trihalomethyl compound, a carbonyl compound, an organic peroxide, an azo compound, an azide compound, a metallocene compound, an organic boron compound, a disulfone compound, an oxime ester compound, an onium salt and a iron arene complex. Among them, at least one compound selected from the hexaarylbisimidazole compound, onium salt, trihalomethyl compound and metallocene compound is preferred, and the hexaarylbisimidazole compound is particularly preferred.

The hexaarylbisimidazole compound includes, for example, lophine dimers described in JP-B-45-37377 (the term "JP-B" as used herein means an "examined Japanese patent publication") and JP-B-44-86516, specifically, 2,2'-bis(o-chlorophenyl)-4,4',5,5'-tetraphenylbismidazole,
2,2'-bis(o-bromophenyl)-4,4',5,5'-tetraphenylbisimidazole,
2,2'-bis(o,p-dichlorophenyl)-4,4',5,5'-tetraphenylbisimidazole,
2,2'-bis(o-chlorophenyl)-4,4',5,5'-tetra(m-methoxyphenyl)bisimidazole,
2,2'-bis(o,o'-dichlorophenyl)-4,4',5,5'-tetraphenylbisimidazole,
2,2'-bis(o-nitrophenyl)-4,4',5,5'-tetraphenylbisimidazole,
2,2'-bis(o-nitrophenyl)-4,4',5,5'-tetraphenylbisimidazole, and
2,2'-bis(o-trifluoromethylphenyl)-4,4',5,5' tetraphenylbisimidazole.

The hexaarylbisimidazole compound is particularly preferably used together with a sensitizing dye having an absorption maximum in a wavelength range from 350 to 450 nm described hereinafter.

The onium salt preferably used in the invention includes a sulfonium salt, an iodonium salt and a diazonium salt. Particularly, a diaryliodonium salt and a triarylsulfonium salt are preferably used. The onium salt is particularly preferably used together with an infrared absorbing agent having an absorption maximum in a wavelength range from 750 to 1,400 nm.

As other polymerization initiator, polymerization initiators known to those skilled in the art can be used without limitation. Specifically, for example, a trihalomethyl compound, a carbonyl compound, an organic peroxide, an azo compound, an azide compound, a metallocene compound, an organic boron compound, a disulfone compound, an oxime ester compound, an onium salt compound and a iron arene complex are exemplified.

In addition, polymerization initiators described in JP-A-2007-171406, JP-A-2007-206216, JP-A-2007-206217, JP-A-2007-225701, JP-A-2007-225702, TP-A-2007-316582 and JP-A-2007-328243 may be used.

The polymerization initiators are preferably used individually or in combination of two or more thereof according to the invention.

The amount of the polymerization initiator used in the photosensitive layer is preferably from 0.01 to 20% by weight, more preferably from 0.1 to 15% by weight, still more preferably from 1.0 to 10% by weight, based on the total solid content of the photosensitive layer from the standpoint of sensitivity and preservation stability.

### (B) Polymerizable compound

The polymerizable compound for use in the photosensitive layer according to the invention is an addition-polymerizable compound having at least one ethylenically unsaturated double bond, and it is selected from compounds having at least one, preferably two or more, terminal ethylenically unsaturated double bonds. The polymerizable compound has a chemical form, for example, a monomer, a prepolymer, specifically, a dimer, a trimer or an oligomer, or a mixture thereof. Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with a polyhydric alcohol compound and amides of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of a polyhydric alcohol compound with an unsaturated carboxylic acid, include, as an acrylic acid ester, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, isocyanuric acid ethylene oxide (EO) modified triacrylate and polyester acrylate oligomer.

As a methacrylic acid ester, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimelhacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane and bis[p-(methacryloxyethoxy)phenyl]dimethylmethane are exemplified.

As an itaconic acid ester, for example, ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate are exemplified. As a crotonic acid ester, for example, ethylene glycol dicrotonate, tetramethylene glycol dicrotonate, pentaerythritol dicrotonate and sorbitol tetracrotonate are exemplified. As an isocrotonic acid ester, for example, ethylene glycol diisocrotonate, pentaerythritol diisocrotonate and sorbitol tetraisocrotonate are exemplified. As a maleic acid ester, for example, ethylene glycol dimaleate, triethylene glycol dimaleate, pentaerythritol dimaleate and sorbitol tetramaleate are exemplified.

Other examples of the ester, which can be preferably used, include aliphatic alcohol esters described in JP-B-51-47334 and JP-A-57-196231, esters having an aromatic skeleton described in JP-A-59-5240, JP-A-59-5241 and JP-A-2-226149, and esters containing an amino group described in JP-A-1-165613.

The above-described ester monomers can also be used as a mixture.

Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferable examples of the amide monomer include amides having a cyclohexylene structure described in JP-B-54-21726.

Urethane type addition-polymerizable compounds produced using an addition reaction between an isocyanate and a hydroxy group are also preferably used and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

CH₂=C(R⁴)COOCH₂CH(R⁵)OH (A)

wherein R⁴ and R⁵ each independently represents H or CH₃.

Also, polymerizable compounds capable of undergoing photo-oxidation are also preferred and, for example, polymerizable compounds containing at least one urea group and/or tertiary amino group described in JP-T-2007-506125 are particularly preferred. Specifically, a compound shown below is exemplified.

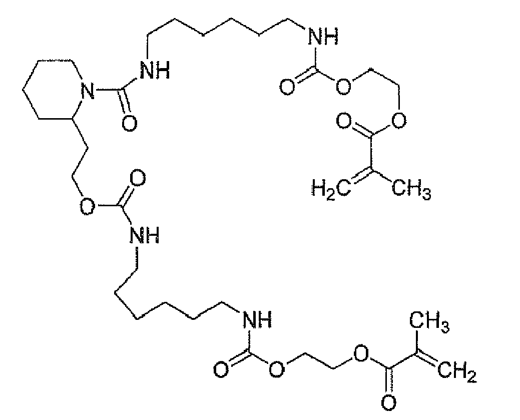

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used. Further, a photosensitive layer having remarkably excellent photo-speed can be obtained by using an addition polymerizable compound having an amino structure or a sulfide structure in its molecule, described in JP-A-63-277653, JP-A-63-260909 and JP-A-1-105238.

Other examples include polyfunctional acrylates and methacrylates, for example, polyester acrylates and epoxy acrylates obtained by reacting an epoxy resin with (meth)acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid type compounds described in JP-A-2-25493 can also be exemplified. In some cases, structure containing a perfluoroalkyl group described in TP-A-61-22048 can be preferably used. Moreover, photocurable monomers or oligomers described in Nippon Secchaku Kyokaishi (Journal of Japan Adhesion Society), Vol. 20, No. 7, pages 300 to 308 (1984) can also be used.

Details of the method of using the polymerizable compound, for example, selection of the structure, individual or combination use or an amount added, can be appropriately determined in accordance with the characteristic design of the final lithographic printing plate precursor. For instance, the compound is selected from the following standpoints.

In view of the sensitivity, a structure having a large content of unsaturated group per molecule is preferred and in many cases, a difunctional or more functional compound is preferred. Also, in order to increase the strength of the image area, that is, cured layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and the strength.

The selection and use method of the polymerizable compound are also important factors for the compatibility and dispersibility with other components (for example, a binder polymer, a polymerization initiator or a coloring agent) in the photosensitive layer. For instance, the compatibility may be improved in some cases by using the compound of low purity or using two or more kinds of the compounds in combination. A specific structure may be selected for the purpose of improving an adhesion property to a support, a protective layer or the like described hereinafter. In the method of using the polymerizable compound, the structure, blend and amount added can be appropriately selected by taking account of the degree of polymerization inhibition due to oxygen, resolution, fogging property, change in refractive index, surface tackiness and the like. Further, depending on the case, a layer construction, for example, an undercoat layer or an overcoat layer, and a coating method, may also be considered.

The polymerizable compound is used preferably in a range from 5 to 75% by weight, more preferably in a range from 25 to 70% by weight, particularly preferably in a range from 30 to 60% by weight, based on the total solid content of the photosensitive layer.

### (C) Sensitizing dye

The photosensitive layer according to the invention contains a sensitizing dye. By incorporating the sensitizing dye, for example, a sensitizing dye having an absorption maximum in a wavelength range from 350 to 450 nm, a sensitizing dye having an absorption maximum in a wavelength range from 500 to 600 nm or an infrared absorbing agent having an absorption maximum in a wavelength range from 750 to 1,400 nm into the photosensitive layer, a highly sensitive lithographic printing plate precursor responding to violet laser of 405 nm, green laser of 532 nm or IR laser of 830 nm ordinarily used in the field of technology can be provided, respectively.

First, the sensitizing dye having an absorption maximum in a wavelength range from 350 to 450 nm is described below.

Such sensitizing dyes include, for example, merocyanine dyes, benzopyrans, coumarins, aromatic ketones and anthracenes.

Of the sensitizing dyes having an absorption maximum in a wavelength range from 350 to 450 mn, dyes represented by formula (IX) shown below are preferred in view of high sensitivity.

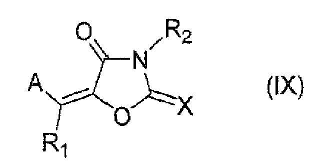

In formula (IX), A represents an aromatic cyclic group which may have a substituent or a heterocyclic group which may have a substituent, X represents an oxygen atom, a sulfur atom or N-(R₃), and R₁, R₂ and R₃ each independently represents a monovalent non-metallic atomic group, or A and R₁ or R₂ and R₃ may be combined with each other to form an aliphatic or aromatic ring.

The formula (IX) will be described in more detail below. R₁, R₂ and R₃ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom.

Now, A in formula (IX) will be described below. A represents an aromatic cyclic group which may have a substituent or heterocyclic group which may have a substituent. Examples of the aromatic cyclic group which may have a substituent and heterocyclic group which may have a substituent include same as those for the substituted or unsubstituted aryl group and substituted or unsubstituted aromatic heterocyclic residue described for any one of R₁, R₂ and R₃ in formula (IX), respectively.

Specific examples of the sensitizing dye include compounds described in Paragraph Nos. [0047] to [0053] of JP-A-2007-58170.

Further, sensitizing dyes represented by formulae (V) or (VI) shown below can also be used.

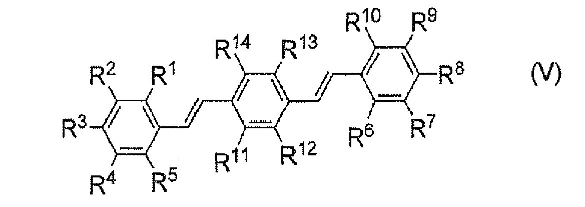

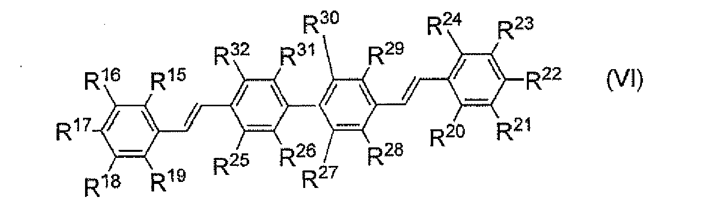

In formula (V), R¹ to R¹⁴ each independently represents a hydrogen atom, an alkyl group, an alkoxy group, a cyano group or a halogen atom, provided that at least one of R¹ to R¹⁰ represents an alkoxy group having 2 or more carbon atoms.

In formula (VI), R¹⁵ to R³² each independently represents a hydrogen atom, an alkyl group, an alkoxy group, a cyano group or a halogen atom, provided that at least one of R¹⁵ to R²⁴ represents an alkoxy group having 2 or more carbon atoms.

Specific examples of these sensitizing dyes include compounds described in EP-A-1349006 and WO 2005/029187.

Sensitizing dyes described in JP-A-2007-171406, JP-A-2007-206216, JP-A-2007-206217, JP-A-2007-225701, JP-A-2007-225702, JP-A-2007-316582 and JP-A-2007-328243 are also preferably used.

Next, the sensitizing dye having an absorption maximum in a wavelength range from 750 to 1,400 preferably used in the invention is described in detail below.

Such sensitizing dyes include infrared absorbing agents and it is believed that the sensitizing dye forms an electron excited state with high sensitivity upon irradiation (exposure) of infrared laser, and electron transfer, energy transfer or heat generation (light-to-heat conversion function) relating to the electron excited state acts on a polymerization initiator coexistent in the photosensitive layer to cause chemical change in the polymerization initiator, thereby generating a radical.

In any event, it is particularly preferred for plate making including direct drawing with an infrared laser having a wavelength from 750 to 1,400 nm to add the sensitizing dye having an absorption maximum in a wavelength range from 750 to 1,400 and the high image-forming property can be generated in comparison with a conventional lithographic printing plate precursor.

The infrared absorbing agent is preferably a dye or pigment having an absorption maximum in a wavelength range from 750 to 1,400 nm.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimme dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As particularly preferable examples of the dye, cyanine dyes represented by formula (a) shown below are exemplified.

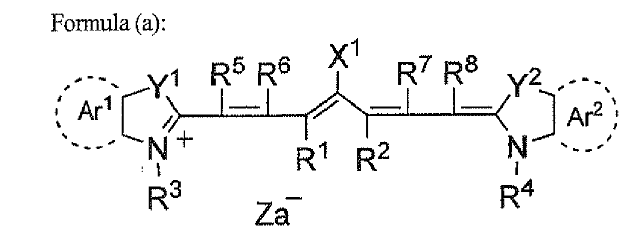

In formula (a), X¹ represents a hydrogen atom, a halogen atom, -NPh₂, X²-L¹ or a group shown below. X² represents an oxygen atom, a nitrogen atom or a sulfur atom, L¹ represents a hydrocarbon group having from 1 to 12 carbon atoms, an aromatic cyclic group containing a hetero atom (a nitrogen atom, a sulfur atom, an oxygen atom, a halogen atom or a selenium atom) or a hydrocarbon group having from 1 to 12 carbon atoms and containing a hetero atom. Xa has the same meaning as Za defined hereinafter. R^{a} represents a hydrogen atom or a substituent selected from an alkyl group, an aryl group, a substituted or unsubstituted amino group and a halogen atom.

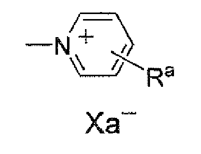

R¹ and R² each independently represents a hydrocarbon group having from 1 to 12 carbon atoms. In view of the preservation stability of a coating solution for photosensitive layer, it is preferred that R¹ and R² each represents a hydrocarbon group having two or more carbon atoms, and it is also preferred that R¹ and R² are combined with each other to form a 5-membered or 6-membered ring.

Ar¹ and Ar², which may be the same or different, each represents an aromatic hydrocarbon group which may have a substituent. Preferable examples of the aromatic hydrocarbon group include a benzene ring group and a naphthalene ring group. Preferable examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent. Preferable examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. In view of the availability of raw materials, a hydrogen atom is preferred. Za⁻ represents a counter anion. However, Za⁻ is not necessary when the cyanine dye represented by formula (a) has an anionic substituent in the structure thereof and neutralization of charge is not needed. Preferable examples of the counter ion for Za⁻ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for photosensitive layer.

Specific examples of the cyanine dye represented by formula (a), which can be preferably used in the invention, include those described in Paragraph Nos. [0017] to [0019] of JP-A-2001-133969.

Further, other particularly preferable examples include specific indolenine cyanine dyes described in JP-A-2002-278057.

Examples of the pigment for use in the invention include commercially available pigments and pigments described in Colour Index (C.I.), Saishin Ganryo Binran (Handbook of the Newest Pigments) compiled by Pigment Technology Society of Japan (1977), Saishin Ganryo Oyou Gijutsu (Newest Application on Technologies for Pigments), CMC Publishing Co., Ltd. (1986) and Insatsu Ink Gijutsu (Printing Ink Technology), CMC Publishing Co., Ltd. (1984).

The amount of the sensitizing dye added is preferably from 0.05 to 30 parts by weight, more preferably from 0.1 to 20 parts by weight, most preferably from 0.2 to 10 parts by weight, in 100 parts by weight of the total solid content of the photosensitive layer.

### (D) Binder polymer

As the binder polymer for use in the photosensitive layer according to the invention, a polymer capable of holding the components of photosensitive layer on a support and capable of being removed with a developer is used. The binder polymer used includes, for example, a (meth)acrylic polymer, polyurethane, polyvinyl alcohol, polyvinyl butyral, polyvinyl formal, polyamide, polyester and epoxy resin. A (meth)acrylic polymer, polyurethane or polyvinyl butyral is more preferred and polyvinyl butyral is still more preferred. When polyvinyl butyral having a hydrophilic group is used as the binder polymer, the occurrence of development scum can be more reduced.

The term "(meth)acrylic polymer" as used herein means a copolymer containing as a polymerization component, (meth)acrylic acid or a (meth)acrylic acid derivative, for example, a (meth)acrylate (including, for example, an alkyl ester, aryl ester and allyl ester), (meth)acrylamide or a (meth)acrylamide derivative. The term "polyurethane" as used herein means a polymer formed by a condensation reaction of a compound having two or more isocyanate groups and a compound having two or more hydroxy groups.

The term "polyvinyl butyral" as used herein means a polymer synthesized by a reaction (acetalization reaction) of polyvinyl alcohol obtained by partial or full saponification of polyvinyl acetate with butylaldehyde under an acidic condition and includes a polymer wherein an acid group or the like is introduced by a method of reacting the remaining hydroxy group with a compound having the acid group or the like.

One preferable example of the (meth)acrylic polymer according to the invention is a copolymer containing a repeating unit having an acid group. Examples of the acid group include a carboxylic acid group, a sulfonic acid group, a phosphonic acid group, a phosphoric acid group and a sulfonamido group and a carboxylic acid group is particularly preferred. A repeating unit derived from (meth)acrylic acid or a repeating unit represented by formula (I-A) shown below is

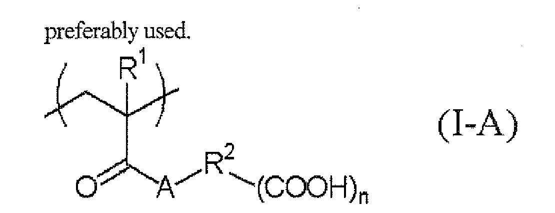

In formula (I-A), R¹ represents a hydrogen atom or a methyl group, R² represents a single bond or an (n+1) valent connecting group, A represents an oxygen atom or -NR³-, wherein R³ represents a hydrogen atom or a monovalent hydrocarbon group having from 1 to 10 carbon atoms, and n represents an integer from 1 to 5.

The connecting group represented by R² in formula (I-A) is preferably constructed from one or more atoms selected from a hydrogen atom, a carbon atom, an oxygen atom, a nitrogen atom, a sulfur atom and a halogen atom and a number of atoms constituting the connecting group represented by R² is preferably from 1 to 80. Specific examples of the connecting group include an alkylene group, a substituted alkylene group, an arylene group and a substituted arylene group. The connecting group may have a structure wherein a plurality of such divalent groups is connected to each other via any of an amido bond, an ether bond, a urethane bond, a urea bond and an ester bond. R² is preferably a single bond, an alkylene group, a substituted alkylene group or a structure where a plurality of at least one of an alkylene group and a substituted alkylene group is connected to each other via at least any of an amido bond, an ether bond, a urethane bond, a urea bond and an ester bond, particularly preferably a single bond, an alkylene group having from 1 to 5 carbon atoms, a substituted alkylene group having from 1 to 5 carbon atoms or a structure where a plurality of at least one of an alkylene group having from 1 to 5 carbon atoms and a substituted alkylene group having from 1 to 5 carbon atoms is connected to each other via at least any of an amido bond, an ether bond, a urethane bond, a urea bond and an ester bond, and most preferably a single bond, an alkylene group having from 1 to 3 carbon atoms, a substituted alkylene group having from 1 to 3 carbon atoms or a structure where a plurality of at least one of an alkylene group having from 1 to 3 carbon atoms and a substituted alkylene group having from 1 to 3 carbon atoms is connected to each other via at least any of an amido bond, an ether bond, a urethane bond, a urea bond and an ester bond.

Examples of the substituent for the substituted alkylene group and substituted arylene group include a monovalent non-metallic atomic group exclusive of a hydrogen atom, for example, a halogen atom (e.g., -F, -Br, -Cl or -I), a hydroxy group, a cyano group, an alkoxy group, an aryloxy group, a mercapto group, an alkylthio group, an arylthio group, an alkylcarbonyl group, an arylcarbonyl group, a carboxyl group and a conjugate base group thereof, an alkoxycarbonyl group, an aryloxycarbonyl group, a carbamoyl group, an aryl group, an alkenyl group and an alkynyl group.

R³ is preferably a hydrogen atom or a hydrocarbon group having from 1 to 5 carbon atoms, particularly preferably a hydrogen atom or a hydrocarbon group having from 1 to 3 carbon atoms, and most preferably a hydrogen atom or a methyl group. n is preferably from 1 to 3, particularly preferably 1 or 2, and most preferably 1.

A ratio (% by mole) of the copolymerization component having a carboxylic acid group in the total copolymerization components of the (meth)acrylic polymer is preferably from 1 to 70% in view of developing property. Considering good compatibility between the developing property and printing durability, it is more preferably from 1 to 50%, and particularly preferably from 1 to 30%.

Preferable specific examples of the repeating unit having a carboxylic acid group are set forth below.

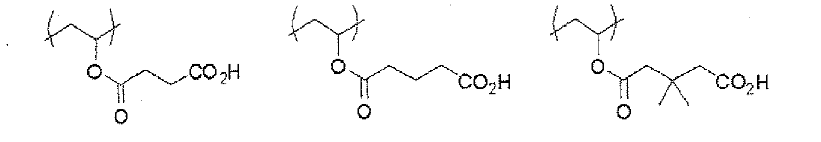

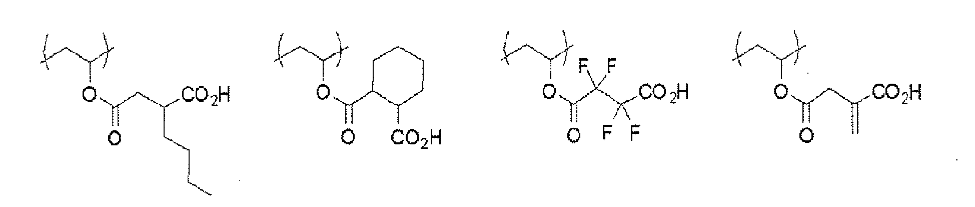

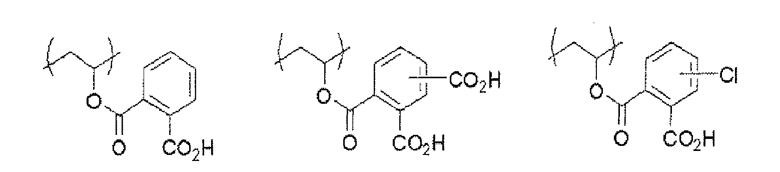

It is preferred that the (meth)acrylic polymer for use in the invention further contain a crosslinkable group. The term "crosslinkable group" as used herein means a group capable of crosslinking the binder polymer in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bond group, an amino group and an epoxy group as a functional group capable of undergoing an addition polymerization reaction. Also, a functional group capable of forming a radical upon irradiation with light may be used and such a crosslinkable group includes, for example, a thiol group and a halogen atom. Among them, the ethylenically unsaturated bond group is preferred. The ethylenically unsaturated bond group preferably includes a styryl group, a (meth)acryloyl group and an allyl group.

In the (meth)acrylic polymer, for example, a free radical (a polymerization initiating radical or a propagating radical in the process of polymerization of the polymerizable compound) is added to the crosslinkable functional group to cause addition polymerization between the polymers directly or through a polymerization chain of the polymerizable compound and as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the (meth)acrylic polymer is preferably from 0.01 to 10.0 mmol, more preferably from 0.05 to 5.0 mmol, particularly preferably from 0.1 to 2.0 mmol, per g of the binder polymer.

The (meth)acrylic polymer for use in the invention may contain a repeating unit of alkyl (meth)acrylate or aralkyl (meth)acrylate, a repeating unit of (meth)acrylamide or a derivative thereof, a repeating unit of α-hydroxymethylacrylate or a repeating unit of a styrene derivative, in addition to the repeating unit having an acid group and the repeating unit having a crosslinkable group described above. The alkyl group in the alkyl (meth)acrylate is preferably an alkyl group having from 1 to 5 carbon atoms or an alkyl group having from 2 to 8 carbon atoms and the substituent described above, and more preferably a methyl group. The aralkyl (meth)acrylate includes, for example, benzyl (meth)acrylate. The (meth)acrylamide derivative includes, for example, N-isoprapylacrylamide, N-phenylmethacrylamide, N-(4-methoxycarbonylphenyl)methacrylamide, N,N-dimethylacrylamide and morpholinoacrylamide. The α-hydroxymethylacrylate includes, for example, ethyl α-hydroxymethylacrylate and cyclohexyl α-hydroxymethylacrylate. The styrene derivative includes, for example, styrene and 4-tret-butylstyrene.

Preferable examples of the polyurethane for use in the invention include polyurethanes described in Paragraph Nos. [0099] to [0210] of JP-A-2007-187836, Paragraph Nos. [0019] to [0100] of JP-A-2008-276155, Paragraph Nos. [0018] to [0107] of JP-A-2005-250438 and Paragraph Nos. [0021] to [0083] of JP-A-2005-250158.

Preferable examples of the polyvinyl butyral for use in the invention include polyvinyl butyrals described in Paragraph Nos. [0006] to [0013] of JP-A-2001-75279.

Further, for example, polyvinyl butyral having an acid group introduced as shown below is also preferably used.

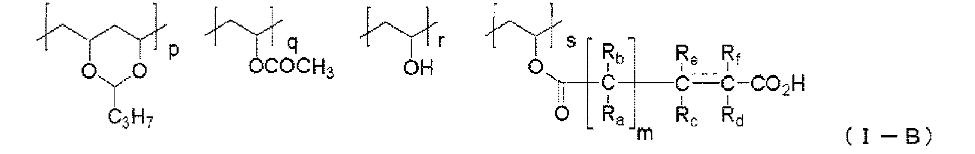

In formula (I-B), a ratio of each repeating unit p/q/r/s is preferably in a range from 50 to 78% by mole/from 1 to 5% by mole/from 5 to 28% by mole/from 5 to 20% by mole.

Rₐ and R_{b} each independently represents a monovalent substituent which may have a substituent, R_{c}, R_{d}, Rₑ and R_{f} each independently represents a monovalent substituent which may have a substituent or a single bond, and m represents an integer from 0 to 1. Preferable examples of any one of Rₐ, R_{b}, R_{c}, R_{d}, Rₑ and R_{f} include a hydrogen atom, an alkyl group which may have a substituent, a halogen atom and an aryl group which may have a substituent. More preferable examples thereof include a hydrogen atom, a straight-chain alkyl group, for example, a methyl group, an ethyl group or a propyl group, an alkyl group substituted with a carboxylic acid, a halogen atom, a phenyl group and a phenyl group substituted with a carboxylic acid. R_{c} and R_{d} or Rₑ and R_{f} may be combined with each other to form a ring structure. The bond between the carbon atom to which R_{c} and Rₑ connect and the carbon atom to which R_{d} and R_{f} connect is a single bond, a double bond or an aromatic double bond and in the case of the double bond or aromatic double bond, R_{c} and R_{d}, Rₑ and R_{f}, R_{c} and R_{f} or Rₑ and R_{d} are connected with each other to form a single bond.

The polyvinyl butyral represented by formula (I-B) can be obtained, for example, by reacting a hydroxy group of a polymer synthesized by a reaction (acetalization reaction) of polyvinyl alcohol obtained by partial or full saponification of polyvinyl acetate with butylaldehyde under an acidic condition with a compound represented by formula (I-B') shown below in a known manner. In formula (I-B'), Rₐ, R_{b}, R_{c}, R_{d}, Rₑ, R_{f} and m have the same meanings as those defined in formula (I-B), respectively.

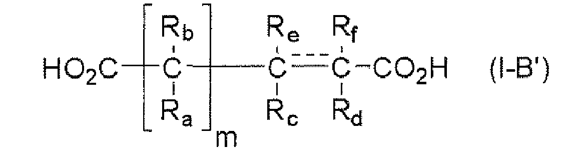

Furhter, the acid group of a polymer having an acid group which is a preferable example of the binder polymer according to the invention may be neutralized with a basic compound. Particularly, it is preferred to be neutralized with a compound having a basic nitrogen atom, for example, an amino group, an amidine group or a guanidine group. It is also preferred that the compound having a basic nitrogen atom has an ethylenically unsaturated group. Specific examples of the compound include compounds described in WO 2007/057442.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymers may be used individually or in combination of two or more thereof. The content of the binder polymer is preferably from 5 to 75% by weight, more preferably from 10 to 70% by weight, still more preferably from 10 to 60% by weight, based on the total solid content of the photosensitive layer from the standpoint of good strength of the image area and good image-forming property.

The total content of the polymerizable compound and the binder polymer is preferably 80% by weight or less based on the total solid content of the photosensitive layer. When it exceeds 80% by weight, decrease in the sensitivity and deterioration in the developing property may be caused sometimes. The total content is more preferably from 35 to 75% by weight.

According to the invention, by controlling a ratio of the polymerizable compound to the binder polymer contained in the photosensitive layer of the lithographic printing plate precursor, the permeability of developer into the photosensitive layer more increases and the developing property is further improved. Specifically, a weight ration of polymerizable compound/binder polymer in the photosensitive layer is preferably 1.2 or more, more preferably from 1.25 to 4.5, and most preferably from 2 to 4.

### (Other components for photosensitive layer)

The photosensitive layer may further contain a radical chain transfer agent as described in European Patent 107792 in order to obtain high sensitivity. As the chain transfer agent, for example, compounds having SH, PH, SiH or GeH in their molecules are used. The compound donates a hydrogen to a low active radical species to generate a radical or is oxidized and then deprotonized to generate a radical. Preferable chain transfer agent includes a sulfur-containing compound, particularly, a thiol, for example, a 2-mercaptobenzothiazole, a 2-mercaptobenzoxazole or a 2-mercaptobenzimidazole. The amount of the chain transfer agent is preferably in a range from 0.01 to 10 parts by weight, more preferably in a range from 0.1 to 2 parts by weight, based on the total solid content of the photosensitive layer.

Into the photosensitive layer, various additives can be further incorporated, if desired. Examples of the additive include a surfactant for progressing the developing property and improving the surface state of coated layer, a microcapsule for providing good compatibility between developing property and printing durability, a hydrophilic polymer for improving the developing property and dispersion stability of microcapsule, a coloring agent or print-out agent for visually distinguishing the image area from the non-image area, a polymerization inhibitor for preventing undesirable thermal polymerization of the radical polymerizable compound during the production and preservation of the photosensitive layer, a higher fatty acid derivative for avoiding polymerization inhibition due to oxygen, a fine inorganic particle for increasing strength of the cured layer in the image area, a hydrophilic low molecular weight compound for improving the developing property, a co-sensitizer for increasing sensitivity, and a plasticizer for improving plasticity. As the additives, known compounds, for example, compounds described in Paragraph Nos. [0161] to [0215] of JP-A-2007-206217 can be used.

### <Formation of photosensitive layer>

The photosensitive layer is formed by dispersing or dissolving each of the necessary constituting components described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and γ-butyrolactone, but the invention should not be construed as being limited thereto. The solvents may be used individually or as a mixture. The solid content concentration of the coating solution is preferably from 1 to 50% by weight.

The coating amount (solid content) of the photosensitive layer after the coating and drying on the support is preferably from 0.3 to 3.0 g/m². Various methods can be used for the coating. Examples of the method include bar coater coating, spin coating, spray coating, curtain coating, dip coating, air knife coating, blade coating and roll coating.

### <Protective layer>

In the lithographic printing plate precursor for use in the method of preparing a lithographic printing plate according to the invention, a protective layer (oxygen-blocking layer) is provided on the photosensitive layer in order to prevent diffusion and penetration of oxygen which inhibits the polymerization reaction at the time of exposure.

The protective layer according to the invention contains a polymer (E) which contains a repeating unit represented by formula (I) shown below and in which a ratio of a repeating unit having a hydroxy group to the total repeating units is 70% by mole or less. When the content of a repeating unit having a hydroxy group to the total repeating units in the polymer (E) exceeds 70% by mole, due to aggregation of hydrogen bonds solubility of the component of the protective layer in a developer decreases so that processing stability particularly deteriorates. From this point of view, the content of a repeating unit having a hydroxy group to the total repeating units in the polymer (E) is preferably 50% by mole or less, more preferably 30% by mole or less, and still more preferably 10% by mole or less. The polymer (E) preferably does not contain a repeating unit having a hydroxy group, but may contain the repeating unit having a hydroxy group. When the polymer (E) contains the repeating unit having a hydroxy group, the content of the repeating unit having a hydroxy group to the total repeating units is ordinarily 0.0 1 % by mole or more.

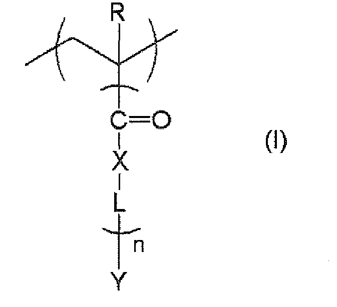

In formula (I), R represents a hydrogen atom or an alkyl group which may have a substituent, X represents an oxygen atom, a sulfur atom or NR₁-, R₁ represents a hydrogen atom or an alkyl group which may have a substituent, L represents a single bond or a connecting group, Y represents -SO₃M, -PO₃M₂ or -COOM, M each independently represents a hydrogen atom, an alkali metal atom or an onium group, and n represents an integer of 0 or more.

The alkyl group for R is preferably an alkyl group having from 1 to 5 carbon atoms, more preferably an alkyl group having from 1 to 3 carbon atoms, still more preferably a methyl group or an ethyl group, and most preferably a methyl group. The alkyl group for R may further have a substituent and the substituent includes, for example, a halogen atom or an alkoxy group (preferably having from 1 to 10 carbon atoms).

The connecting group for L may be straight-chain or branched and is preferably a divalent connecting group having from 1 to 15 carbon atoms. Of the connecting groups, an alkylene group having from 1 to 10 carbon atoms, an arylene group having from 6 to 10 carbon atoms and an aralkylene group having from 7 to 15 carbon atoms are preferred and an alkylene group having from 1 to 5 carbon atoms is more preferred. As the connecting group for L, a polyalkylene oxide group, for example, a polyethylene oxide group or a polypropylene oxide group is also preferably used. A repeating unit number of the alkylene oxide unit is preferably from 1 to 50, more preferably from 1 to 10, and still more preferably from 1 to 5.

The alkali metal atom for M includes, for example, sodium and potassium.

The onium group for M is preferably an onium salt containing a nitrogen atom, a phosphorus atom or a sulfur atom, and more preferably an onium salt containing a nitrogen atom. The onium salt containing a nitrogen atom preferably includes an ammonium salt.

X is preferably NR₁-. R₁ represents a hydrogen atom or an alkyl group which may have a substituent. The alkyl group which may have a substituent for R₁ is same as that described for R

Y is preferably -SO₃M from the standpoint of solubility of the protective layer in a developer.

With respect to specific examples of Y, from the standpoint of solubility of the protective layer in a developer, -SO₃H, -SO₃Na or -COONa is preferred, and -SO₃Na is more preferred.

n is preferably an integer from 0 or 5, more preferably an integer from 0 or 3, still more preferably 0 or 1, and most preferably 1.

A molar ratio of the repeating unit represented by formula (I) to the total repeating units constituting the polymer (E) is ordinarily from 5 to 100% by mole, preferably from 7 to 50% by mole, and more preferably from 9 to 25% by mole.

Specific examples of the repeating unit represented by formula (I) are set forth below, but the invention should not be construed as being limited thereto. In the specific examples shown below R' represents a hydrogen atom or a methyl group.

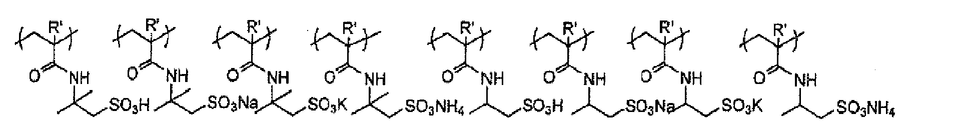

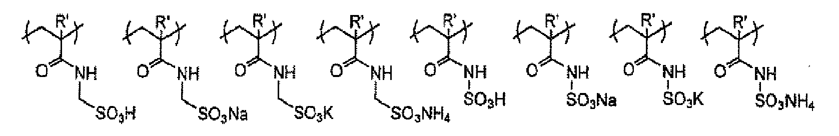

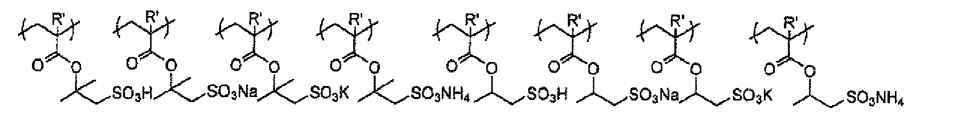

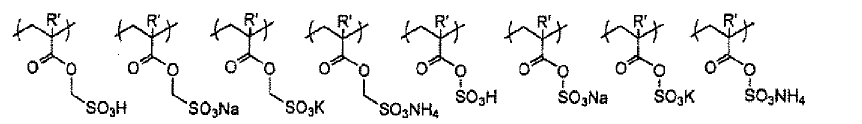

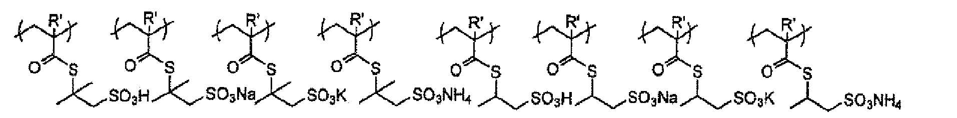

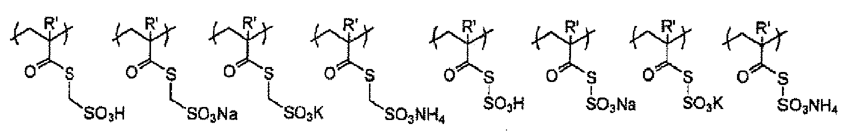

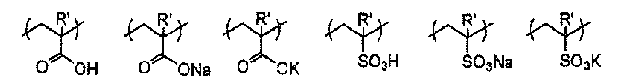

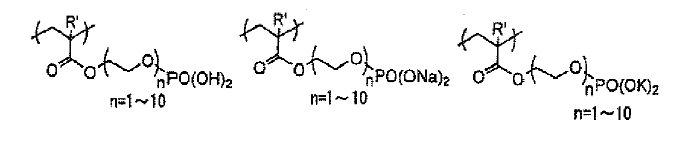

The polymer (E) for use in the invention may be a copolymer containing other repeating unit, for example, a repeating unit of alkyl ester of (meth)acrylic acid, a repeating unit of aralkyl ester of (meth)acrylic acid, a repeating unit of (meth)acrylamide or derivative thereof, a repeating unit of α-hydroxymethyl acrylate or a repeating unit of styrene derivative in addition to the repeating unit represented by formula (I).

The alkyl ester of (meth)acrylic acid includes, for example, methyl (meth)acrylate, ethyl (meth)acrylate or propyl (meth)acrylate. The aralkyl ester of (meth)acrylic acid includes, for example, benzyl (meth)acrylate. The (meth)acrylamide derivative includes, for example, N-isopropylacrylamide, N-phenylmethacrylamide, N-(4-methoxycarbonylphenyl)methacrylamide, N,N-dimethylacrylamide or morpholinoacrylamide. The α-hydroxymethylacrylate includes, for example, ethyl α-hydroxymethylacrylate or cyclohexyl α-hydroxymethylacrylate. The styrene derivative includes, for example, styrene, 4-tert-butylstyrene or a metal salt of p-styrenesulfonic acid.

The other repeating unit is preferably a repeating unit of alkyl ester of (meth)acrylic acid.

The other repeating units may be used individually or in combination of two or more thereof.

A molar ratio of the other repeating unit to the total repeating units constituting the polymer (E) is ordinarily from 10 to 90% by mole, preferably from 10 to 70% by mole, and more preferably from 10 to 50% by mole.

Specific examples of the polymer (E) according to the invention include compounds set forth below, but the invention should not be construed as being limited thereto.

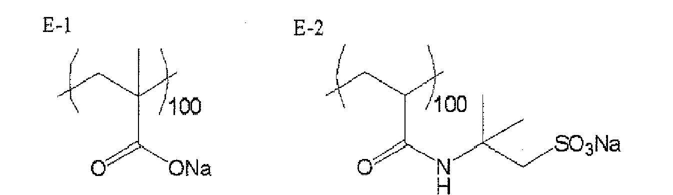

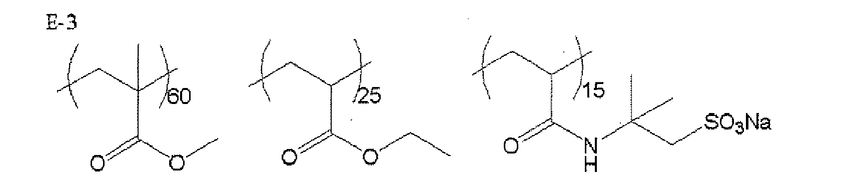

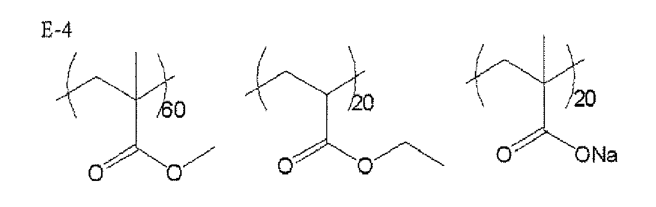

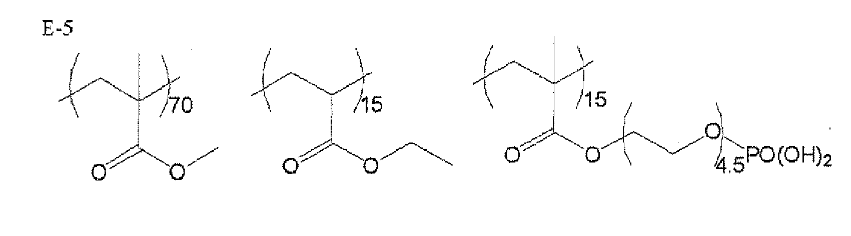

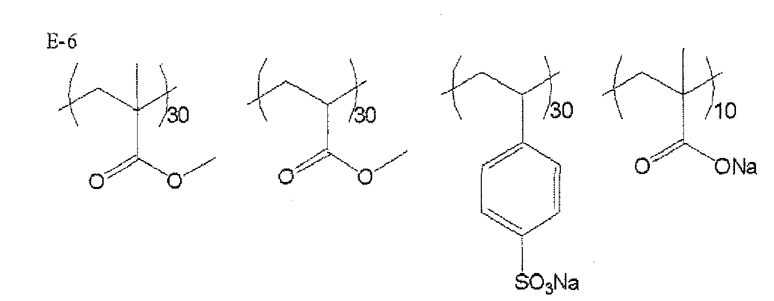

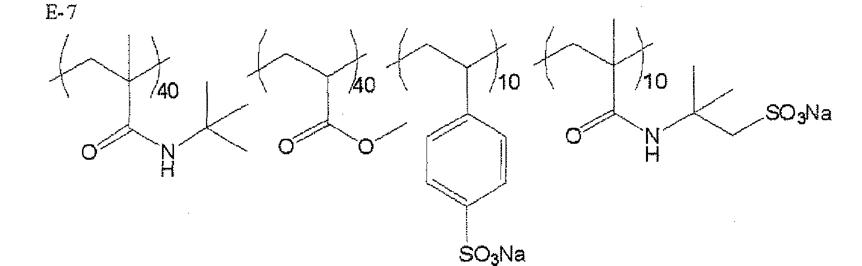

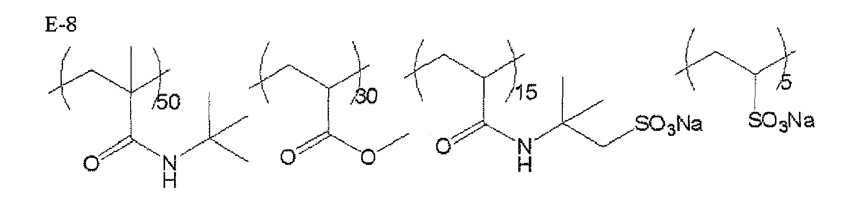

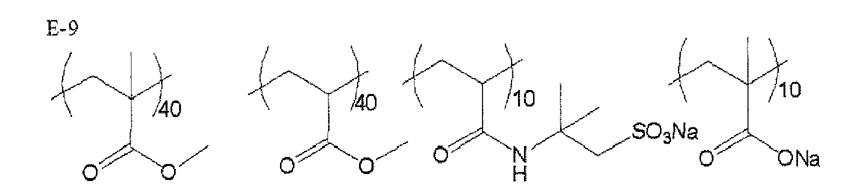

The weight average molecular weight (measured by a GPC method and calculated in terms of polystyrene) of the polymer (E) is preferably from 5,000 to 100,000, and more preferably from 10,000 to 50,000.

As the polymer (E), a commercially available compound may be used or a compound synthesized by a known method, for example, a radical polymerization method may be used.

The amount of the polymer (E) added to the protective layer is preferably from more than 0% by weight to less than 50% by weight, more preferably from 1.0 to 10.0% by weight, still more preferably from 1.0 to 5.0% by weight, particularly preferably from 1.5 to 2.9% by weight, based on the total solid content of the protective layer.

The protective layer preferably further contains a water-soluble polymer compound different from the polymer containing a repeating unit represented by formula (I). The water-soluble polymer compound includes a water-soluble polymer, for example, polyvinyl alcohol, vinyl alcohol/vinyl phthalate copolymer, vinyl acetate/vinyl alcohol/vinyl phthalate copolymer, polyvinyl pyrrolidone, acidic cellulose, gelatin, gum arabic or polyurethane. The water-soluble polymer compounds may be used individually or as a mixture. Of the compounds, a water-soluble polymer compound relatively excellent in crystallizability is preferably used. Specifically, when polyvinyl alcohol is used as the main component, the best results can be obtained in the fundamental characteristics, for example, oxygen-blocking property and removability by development.

Polyvinyl alcohol for use in the protective layer may be partially substituted with an ester, ether or acetal as long as it contains unsubstituted vinyl alcohol units for achieving the necessary oxygen-blocking property and water solubility. Also, polyvinyl alcohol may partly have other copolymer component. Polyvinyl alcohol is obtained by hydrolysis of polyvinyl acetate. As specific examples of the polyvinyl alcohol, those having a hydrolysis degree from 71 to 100% by mole and a repeating unit number from 300 to 2,400 are exemplified.

Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). The polyvinyl alcohols can be used individually or as a mixture.

Two kinds of polyvinyl alcohols different in the saponification degree may be used. For example, a combination of polyvinyl alcohol having a saponification degree from 90 to 100% and polyvinyl alcohol having a saponification degree from 71 to 90% is preferably used.

Also, known modified polyvinyl alcohol can be preferably used as the polyvinyl alcohol. Particularly, an acid-modified polyvinyl alcohol having a carboxylic acid group or a sulfonic acid group is preferably used. Specific examples of the acid-modified polyvinyl alcohol include as the carboxylic acid-modified polyvinyl alcohol, for example, KL-118 (saponification degree: 97% by mole, average polymerization degree: 1,800), KM-618 (saponification degree: 94% by mole, average polymerization degree: 1,800), KM-118 (saponification degree: 97% by mole, average polymerization degree: 1,800) and KM-106 (saponification degree: 98.5% by mole, average polymerization degree: 600) produced by Kuraray Co., Ltd., Gosenal T-330H (saponification degree: 99% by mole, average polymerization degree: 1,700), Gosenal T-330 (saponification degree: 96.5% by mole, average polymerization degree: 1,700), Gosenal T-350 (saponification degree: 94% by mole, average polymerization degree: 1,700), Gosenal T-230 (saponification degree: 96.5% by mole, average polymerization degree: 1,500), Gosenal T-215 (saponification degree: 96.5% by mole, average polymerization degree: 1,300) and Gosenal T-HS-1 (saponification degree: 99% by mole, average polymerization degree: 1,300) produced by Nippon Synthetic Chemical Industry Co., Ltd., and AF-17 (saponification degree: 96.5% by mole, average polymerization degree: 1,700) and AT-17 (saponification degree: 93.5% by mole, average polymerization degree: 1,700) produced by Japan VAM & Poval Co., Ltd.

Also, as the sulfonic acid-modified polyvinyl alcohol, for example, SK-5102 (saponification degree: 98% by mole, average polymerization degree: 200) produced by Kuraray Co., Ltd. and Goseran CKS-50 (saponification degree: 99% by mole, average polymerization degree: 300) and Goseran L-3266 (saponification degree: 88% by mole, average polymerization degree: 300) produced by Nippon Synthetic Chemical Industry Co., Ltd. are exemplified.

The content of the water-soluble polymer compound different from the polymer containing a repeating unit represented by formula (I) in the protective layer is preferably from 20 to 98% by weight, and more preferably from 30 to 95% by weight.

As other component of the protective layer, glycerin, dipropylene glycol or the like can be added in an amount corresponding to several % by weight based on the total solid content of the protective layer to provide flexibility. Further, an anionic surfactant, for example, sodium alkylsulfate or sodium alkylsulfonate, an amphoteric surfactant, for example, alkylaminocarboxylate and alkylaminodicarboxylate, or a nonionic surfactant, for example. polyoxyethylene alkyl phenyl ether can be added in an amount of several % by weight based on the total solid content of the protective layer.

Further, it is also preferred to incorporate an inorganic stratiform compound as described in Paragraph Nos. [0018] to [0024] of JP-A-2006-106700 into the protective layer for the purpose of improving the oxygen-blocking property and property for protecting the surface of photosensitive layer. Of the inorganic stratiform compounds, fluorine based swellable synthetic mica, which is a synthetic inorganic stratiform compound, is particularly useful.

As for the particle size of the inorganic stratiform compound, an average major axis is ordinarily from 0.3 to 20 µm, preferably from 0.5 to 5 µm. An average thickness of the particle is ordinarily 0.1 µm or less, preferably 0.05 µm or less, and particularly preferably 0.01 µm or less.

The content of the inorganic stratiform compound in the protective layer is preferably from 5/1 to 1/100 in terms of weight ratio to the total amount of all polymer compounds (including the polymer compound containing a repeating unit represented by formula (I)) included in the protective layer. When a plurality of the inorganic stratiform compounds is used in combination, it is also preferred that the total amount of the inorganic stratiform compounds fulfill the above-described weight ratio.

The coating amount of the protective layer is preferably in a range from 0.05 to 10 g/m² in terms of the coating amount after drying. When the protective layer contains the inorganic stratiform compound, it is more preferably in a range from 0.1 to 5 g/m², and when the protective layer does not contain the inorganic stratiform compound, it is more preferably in a range from 0.5 to 5 g/m²_{.}

### <Hydrophilic support>

A hydrophilic support for use in the invention is not particularly restricted as long as it is a dimensionally stable plate-like hydrophilic support. Particularly, an aluminum plate is preferred. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the treatments, methods described in Paragraph Nos. [0241] to [0245] of JP-2007-206217 are preferably used.

The center line average roughness of the hydrophilic support is preferably from 0.10 to 1.2 µm. In the range described above, good adhesion property to the photosensitive layer, good printing durability and good resistance to stain are achieved.

The color density of the hydrophilic support is preferably from 0.15 to 0.65 in terms of the reflection density value. In the range described above, good image-forming property by preventing halation at the image exposure and good aptitude for plate inspection after development are achieved.

The thickness of the hydrophilic support is preferably from 0.1 to 0.6 mm, more preferably from 0.15 to 0.4 mm, and still more preferably from 0.2 to 0.3 mm.

### <Hydrophilizing treatment of support and undercoat layer>

According to the invention, in order to increase hydrophilicity of the non-image area and to prevent printing stain, it is possible to conduct a hydrophilizing treatment of the surface of hydrophilic support or to provide an undercoat layer between the hydrophilic support and the photosensitive layer.

The hydrophilizing treatment of the surface of hydrophilic support includes an alkali metal silicate treatment method wherein the hydrophilic support is subjected to an immersion treatment or an electrolytic treatment in an aqueous solution, for example, of sodium silicate, a method of treating with potassium fluorozirconate and a method of treating with polyvinylphosphonic acid. An immersion treatment in an aqueous polyvinylphosphonic acid solution is preferably used.

As the undercoat layer, an undercoat layer containing a compound having an acid group, for example, a phosphonic acid group, a phosphoric acid group or a sulfonic acid group is preferably used. It is preferred for the compound to further have a polymerizable group in order to increase the adhesion property to the photosensitive layer. Also, a compound having a hydrophilicity-imparting group, for example, an ethyleneoxy group is exemplified as a preferable compound. These compounds may be low molecular weight compounds or polymer compounds. For example, a silane coupling agent having an addition-polymerizable ethylenic double bond reactive group described in JP-A-10-282679 and a phosphorus-containing compound having an ethylenic double bond reactive group described in JP-A-2-304441 are preferably exemplified.

As the most preferred undercoat layer, an undercoat layer containing a low molecular weight compound or polymer compound having a crosslinkable group (preferably an ethylenically unsaturated bond group), a functional group capable of interacting with the surface of support and a hydrophilic group described in JP-A-2005-238816, JP-A-2005-125749, JP-A-2006-239867 and JP-A-2006-215263 is exemplified.

The coating amount (solid content) of the undercoat layer is preferably from 0.1 to 100 mg/m², and more preferably from 1 to 30 mg/m².

### <Backcoat layer>

A backcoat layer may also be provided on the back surface of the hydrophilic support, if desired. The backcoat layer can be formed on the back surface of the hydrophilic support, for example, after applying the surface treatment to the support or forming the undercoat layer on the support.

The backcoat layer preferably includes, for example, a layer comprising an organic polymer compound described in JP-A-5-45885 and a coating layer comprising a metal oxide obtained by hydrolysis and polycondensation of an organic metal compound or inorganic metal compound described in JP-A-6-35174. Among them, use of an alkoxy compound of silicon, for example, Si(OCH₃)4, Si(OC₂H₅)₄, Si(OC₃H₇)₄ or Si(OC₄H₉)₄ is preferred since the starting material is inexpensive and easily available.

### [Method of preparing lithographic printing plate]

The method of preparing a lithographic printing plate according to the invention contains after exposing the lithographic printing plate precursor described above with laser, a developing step of removing the protective layer and the unexposed area of the photosensitive layer at the same time in the presence of a developer containing a surfactant and does not contain a water washing step (that is, the water washing step is not conducted between the exposing step of laser exposure and the developing step and after the developing step). Specifically, in the method of preparing a lithographic printing plate according to the invention, the developing step can be conducted by one bath (by one developing tank) containing a developer.

Each of the steps will be described in detail below.

### <Exposing step>

The exposing step is conducted by exposing the lithographic printing plate precursor with laser through a transparent original having a line image, a halftone dot image or the like, or imagewise exposing the lithographic printing plate precursor by scanning of laser beam based on digital data, prior to the development processing.

The wavelength of the exposure light source is preferably from 300 to 450 nm or from 750 to 1,400 nm. In case of exposing with light from 300 to 450 nm, the lithographic printing plate precursor having a photosensitive layer containing a sensitizing dye having an absorption maximum in such a wavelength range is used. In case of exposing with light from 750 to 1,400 nm, the lithographic printing plate precursor containing an infrared absorbing agent which is a sensitizing dye having an absorption in such a wavelength range is used. As the light source having a wavelength from 300 to 450 nm, a semiconductor laser is preferably used. As the light source having a wavelength from 750 to 1,400 nm, a solid laser or semiconductor laser emitting an infrared ray is preferably used. The exposure mechanism may be any of an internal drum system, an external drum system and a flat bed system.

### <Developing step>

The lithographic printing plate precursor according to the invention is exposed imagewise and then subjected to development processing to prepare a lithographic printing plate. The development processing is preferably conducted by a method of developing with one bath containing a developer having pH from 2.0 to 10.9. According to such one bath development, a lithographic printing plate obtained after the development can be mounted on a printing machine to perform printing without conducting removal of the developer with water washing. Further, since the protective layer contains the polymer (E), the protective layer is excellent in solubility in the developer having pH in such a range and thus, the developing property is good and the occurrence of development scum can be prevented.

Temperature of the development is ordinarily approximately from 0 to 60°C, preferably from 10 to 50°C, and more preferably from 15 to 40°C.

The development processing according to the invention is performed, for example, by a method wherein the imagewise exposed lithographic printing plate precursor is immersed in the developer and rubbed with a brush or a method wherein the developer is sprayed to the imagewise exposed lithographic printing plate precursor and the lithographic printing plate precursor is rubbed with a brush. For example, the development processing is preferably performed by an automatic development processor equipped with a supplying means for the developer and a rubbing member. An automatic development processor using a rotating brush roller as the rubbing member is particularly preferred.

Further, the automatic development processor is preferably provided with a means for removing the excess developer, for example, a squeeze roller, or a drying means, for example, a hot air apparatus, subsequently to the development processing means.

A specific example of the automatic development processor is described hereinafter. (Developer)

The developer containing a surfactant for use in the method of preparing a lithographic printing plate according to the invention is preferably an aqueous solution containing water as the main component (containing 60% by weight or more of water). The pH of the developer is preferably from 2.0 to 10.9, more preferably from 5.0 to 10.7, still more preferably from 6.0 to 10.5, and most preferably from 6.9 to 10.3.

The developer may contain an alkali agent. When the developer contains an alkali agent, the pH thereof is preferably in a range form 9.0 to 10.9, more preferably from 9.3 to 10.5, and still more preferably from 9.4 to 10.2. When the developer dose not contain an alkali agent, the pH thereof is preferably in a range form 2.0 to 9.0, more preferably from 4.0 to 8.0, and still more preferably from 4.5 to 7.5.

The developer for use in the invention contains a surfactant. The surfactant used includes, for example, anionic, nonionic, cationic and amphoteric surfactants.

The anionic surfactant is not particularly limited and includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant is not particularly limited, and for example, alkylamine salts, quaternary ammonium salts, polyoxyethylene alkyl amine salts and polyethylene polyamine derivatives are exemplified.

The nonionic surfactant is not particularly limited and includes, for example, polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Of the compounds, those having an aromatic ring and an ethylene oxide chain are preferred, and alkyl-substituted or unsubstituted phenol ethylene oxide adducts and alkyl-substituted or unsubstituted naphthol ethylene oxide adducts are more preferred.

The amphoteric surfactant is not particularly limited and includes, for example, amine oxide type, for example, alkyldimethylamine oxide, betaine type, for example, alkyl betaine and amino acid type, for example, sodium salt of alkylamino fatty acid.

In particular, an alkyldimethylamine oxide which may have a substituent, an alkyl carboxy betaine which may have a substituent and an alkyl sulfo betaine which may have a substituent are preferably used. Specific examples of the compound are described, for example, in Paragraph Nos. [0255] to [0278] of JP-A-2008-203359 and Paragraph Nos. [0028] to [0052] of JP-A-2008-276166.

Two or more of the surfactants may be used in combination, and the content of the surfactant in the developer is preferably from 0.01 to 20% by weight, and more preferably from 0.1 to 10% by weight.

The developer of the invention may contain a water-soluble polymer compound. The water-soluble polymer compound includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer, a styrene/maleic anhydride copolymer and polystyrenesulfonic acid.

As the soybean polysaccharide, known soybean polysaccharide can be used. For example, as a commercial product, SOYAFIVE (trade name, produced by Fuji Oil Co., Ltd.) is available and various grade products can be used. The soybean polysaccharide preferably used is that having viscosity in a range from 10 to 100 mPa/sec in the 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound in the developer is preferably from 0.1 to 20% by weight, and more preferably from 0.5 to 10% by weight.

The developer for use in the invention preferably further contains a pH buffer agent.

As the pH buffer agent used in the invention, a buffer agent exhibiting a buffer function at pH from 2 to 10.9 is preferably. A weak alkaline pH buffer agent is more preferably used. The pH buffer agent specifically includes, for example, (a) a carbonate ion and a hydrogen carbonate ion, (b) a borate ion, (c) a water-soluble organic amine compound and an ion of the water-soluble organic amine compound, and a combination thereof. Specifically, for example, (a) a combination of a carbonate ion and a hydrogen carbonate ion, (b) a borate ion, or (c) a combination of a water-soluble organic amine compound and an ion of the water-soluble organic amine compound exhibits a pH buffer function in the developer to prevent fluctuation of the pH even when the developer is used for a long period of time. As a result, for example, the deterioration of developing property resulting from the fluctuation of pH and the occurrence of development scum are restrained. The combination (a) of a carbonate ion and a hydrogen carbonate ion or the combination (c) of a water-soluble organic amine compound and an ion of the water-soluble organic amine compound is particularly preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof Examples of the alkali metal include lithium, sodium and potassium and sodium is particularly preferred. The alkali metals may be used individually or in combination of two or more thereof.

In case of adopting (a) the combination of a carbonate ion and a hydrogen carbonate ion as the pH buffer agent, the total amount of the carbonate ion and hydrogen carbonate ion is preferably from 0.05 to 5 mole/l, more preferably from 0.1 to 2 mole/l, particularly preferably from 0.2 to 1 mole/l, in the developer.

The water-soluble organic amine compound or an ion of the water-soluble organic amine compound is not particularly restricted and is preferably elected from monoethanol amine, diethanol amine, triethanol amine, N-hydroxyethylnorpholine and 4-dimethylaminopyridine. The water-soluble organic amine compounds may be used in combination of two or more thereof. By using the water-soluble organic amine compound, good developing property and processing stability are achieved even in the pH range near to neutral.

In the case where (c) the combination of a water-soluble organic amine compound and an ion of the water-soluble organic amine compound is used as the pH buffer agent, the amount of the compound used is preferably from 0.005 to 5 mol/l, more preferably from 0.01 to 2 mol/l, particularly preferably from 0.01 to 1 mol/l, in mole concentration in the developer.

The developer may contain an enzyme, preferably a hydrolytic enzyme. By processing with the developer containing an enzyme, improvement in the stain preventing property and prevention of the occurrence of development scum can be achieved because the ethylenically unsaturated compound is hydrolyzed in the developer to increase hydrophilicity. Further, in the case of hydrolysis of an ester group, since polarity conversion (polarity conversion from hydrophobicity to hydrophilicity) is utilized, penetration of the developer into the image area hardly occurs so that the improvement in the stain preventing property and prevention of the occurrence of development scum can be achieved while maintaining the sensitivity and printing durability.

With respect to the enzyme for use in the invention, the kind thereof is not particularly restricted, as long as the enzyme has a function of preventing the occurrence of development scum in the development processing of a lithographic printing plate precursor having a photopolymerizable photosensitive layer. The groups of enzymes as described in Koso Handbook (Enzyme Handbook) Third Edition, edited by Tatsuhiko Yagi et al, Asakura Publishing Co., Ltd. are appropriately used. In particular, for the purpose of decomposition and solubilization of the polymerizable compound (ethylenically unsaturated compound), the hydrolytic enzymes belonging to the enzyme number (EC number) of Group EC3. by Enzyme Commission of Congress of Biochemistry and Molecular Biology (IUBMB) are preferably used. Since the ethylenically unsaturated compounds are composed, for example, of a carbon atom, a hydrogen atom, a nitrogen atom, an oxygen atom, a sulfur atom, a phosphorus atom and a halogen atom in many cases, an enzyme capable of hydrolyzing a carboxylic acid ester bond, an enzyme capable of hydrolyzing a phosphoric acid ester, an enzyme capable of hydrolyzing a sulfuric acid ester, an enzyme capable of hydrolyzing an ether bond, an enzyme capable of hydrolyzing a thioether bond, an enzyme capable of hydrolyzing a peptide bond, an enzyme capable of hydrolyzing a carbon-carbon bond, an enzyme capable of hydrolyzing a carbon-halogen bond and the like are exemplified as preferred enzymes. The enzymes capable of hydrolyzing at least one member selected from the group consisting of an ester bond, an amido bond, a tertiary amino group, a urethane bond, a urea bond, a thiourethane bond and a thiourea bond are more preferred.

Of the enzymes, those belonging to Group EC3.1 (ester hydrolytic enzyme) and Group EC3.4 (peptide bond hydrolytic enzyme) are preferred, and EC3.1.1.3 (triacylglycerol lipase), EC3.4.11.1 (leucyl aminopeptidase), EC3.4.21.62 (subtilisin), EC3.4.21.63 (oryzin), EC3.4.22.2 (papain), EC3.4.22.32 (stem bromelain), EC3.4.23.18 (aspergillopepsin I), EC3.4.24.25 (vibriolysin), EC3.4.24.27 (thermolysin) and EC3.4.24.28 (bacillolysin) are preferred. Further, EC3.1.1.3, EC3.4.21.14, EC3.4.21.62 and EC3.4.21.63 are most preferred.

As described above, in view of the developing property and environment the pH of the developer is preferably from 2.0 to 10.9, more preferably from 5.0 to 10.7, still more preferably from 6.0 to 10.5, and particularly preferably from 6.9 to 10.3.

From this point of view, as the enzyme, an alkali enzyme is preferably used. The term "alkali enzyme" as used herein means an enzyme which has an optimum pH range in an alkaline range. The enzyme having the optimum pH range from 7.0 to 11.0 is preferred. The enzyme having an optimum temperature range from 20 to 60°C is preferred, and that having an optimum temperature range from 30 to 55°C is more preferred.

Specifically, an enzyme capable of mainly hydrolyzing an ester group of the polymerizable compound under an alkali condition, for example, alkali protease or alkali lipase is preferred. As the alkali protease, enzymes of microbial origin, for example, Bacillus subtilis, Aspergillus oryzae, Bacillus stearothermophilus, papaya latex, papaya, Ananas comosus M, Pig pancreas, Bacillus licheniformis, Aspergillus melleus, Aspergillus sp., Bacillus lentus, Bacillus sp. and Bacillus clausii are exemplified. As the alkali lipase, enzymes of microbial origin, for example, Candida cylindracea, Humicola lanuginosa, Psudomonas, Mucor sp., Chromobacterium viscosum, Rhizopus japonics, Aspergillus niger, Mucor javanicus, Penicillium camemberti, Rhizopus oryzae, Candida rugosa, Penicillium roqueforti, Rhizopus delemar, Psendomonas sp., Aspergillus sp., Rhizomucor miehei, Bacillus sp. and Alcaligenes sp. are exemplified.

More specifically, Lipase PL, Lipase QLM, Lipase SL, Lipase MY and Lipase OF (produced by Dai-Nippon Meiji Sugar Co., Ltd.), Newlase F3G, Lipase A "Amano", Lipase AY "Amano" 30G, Lipase G "Amano" 50, Lipase R "Amano", Lipase AS "Amano", Umamizayme G, Papain W-40, Protease A "Amano" G, Protease N "Amano" G, Protease NL "Amano", Protease P "Amano" 3G, Protease S "Amano" G, Bromelain F, Proleather FG-F, Peptidase R, Thermoase PC10F, Protin SD-AC10F, Protin SD-AY10, Protin SD-PC10F, Protin SD-NY10, Spleen digestive enzyme TA, Prozyme, Prozyme 6, Semi-Alkaline Proteinase, Lipase AYS "Amano", Lipase PS "Amano" SD, Lipase AK "Amano", Lipase PS "Amano" IM, Protease N "Amano", Protease S "Amano", Acylase "Amano" and D-Amino acylase "Amano" (produced by Amano Enzyme Inc.), Alcalase, Espelase, Sabinase, Ebalase, Kannase, Lipolase, Lipex, NS44020, NS44120, NS44060, NS44114, NS44126 and NS44160 produced by Novozymes Japan Ltd.), Alkaline protease (produced by Takeda Chemical Industries, Ltd.), Aroase XA-10 (produced by Yakult Pharmaceutical Industry Co., Ltd.), Alkali Protease GL, Protex 6L, Purafect, Purafect OX, Propelase, Protex OXG and Protex 40L (produced by Genencor Kyowa Co., Ltd.), Sumizyme MP (produced by Shin-Nihon Kagaku Kogyo Co., Ltd.), Bioplase OP, Bioplase AL-15KG, Bioplase 30G, Bioplase APL-30, Bioplase XL-416F, Bioplase SP-20FG, Bioplase SP-4FG and Protease CL-15 (produced by Nagase Chemtex Corp.), Orientase (produced by HBI Enzymes Inc.) and Enzylon SA (produced by Rakuto Kasei Industry Co., Ltd.).

With respect to the method for introduction of the enzyme, the enzyme may be directly incorporated into the developer or may be added at the time of processing of a lithographic printing plate precursor. Also, the development processing may be conducted while supplying the enzyme to the developer.

The amount of the enzyme added is preferably from 0.0001 to 5% by weight, more preferably from 0.001 to 1% by weight, particularly preferably from 0.001 to 0.3% by weight, based on the total amount of the developer.

The developer according to the invention may contain a preservative, a chelating agent, a defoaming agent, an organic acid, an inorganic acid, an inorganic salt or the like in addition the components described above. Specifically, compounds described in Paragraph Nos. [0266] to [0270] of JP-A-2007-206217 are preferably used.

The developer described above can be used as a development replenisher. In the case of conducting the development using an automatic development processor, the developer becomes fatigued in accordance with the processing amount, and hence the processing ability may be restored using a replenisher or a fresh developer.

### <Drying step>

After the developing step, a drying step is conducted.

With respect to the drying means, a heating means is not particularly restricted and a heating means ordinarily used in the drying of such a lithographic printing plate precursor can be used without particular limitations. Specifically, the heating can be conducted, for example, with hot air, infrared ray or far-infrared ray.

The plate surface temperature of the lithographic printing plate precursor in the drying step is from 30 to 80°C, preferably from 40 to 80°C, more preferably from 50 to 80°C, and particularly preferably from 60 to 80°C. When the plate surface temperature is too low, the lithographic printing plate precursor is not sufficiently dried to cause a problem of stickiness or the like. When the plate surface temperature is too high, the volatile components volatilize so that odor generation is more likely to occur.

The plate surface temperature in the drying step as used herein means temperature in a position corresponding to the center on the processed side of the lithographic printing plate precursor immediately after the drying step. The plate surface temperature is temperature determined by noncontact measurement using a radiation thermometer. The heating time in the drying step is preferably from 1 to 20 seconds, and more preferably from 5 to 10 seconds.

The present invention is characterized in that a water washing step is not included between the developing step and the drying step. Also, according to the invention, conventional development processing and gum solution treatment are possible to conduct with one bath so that the processing steps can be remarkably simplified.

Moreover, a pre-water washing step is also not particularly necessary and removal of the protective layer is possible to conduct simulteniously with the development processing and gum solution treatment.

Further, in the method of preparing a lithographic printing plate according to the invention, the entire surface of the lithographic printing plate precursor may be heated before the exposure, during the exposure or between the exposure and the development, if desired. By the heating, the image-forming reaction in the photosensitive layer is accelerated and advantages, for example, improvement in the sensitivity and printing durability and stabilization of the sensitivity may be achieved. For the purpose of increasing the image strength and printing durability, it is also effective to perform entire after-heating or entire exposure of the image after the development. Ordinarily, the heating before the development is preferably performed under a mild condition of 150°C or lower. When the temperature is too high, a problem may arise sometimes in that the unexposed area is also cured. On the other hand, the heating after the development can be performed using very strong conditions. Ordinarily, the heat treatment is carried out in a temperature range from 100 to 500°C. When the temperature is too low, the sufficient effect of strengthening the image may not be obtained, whereas when it is excessively high, problems of deterioration of the support and thermal decomposition of the image area may occur sometimes.

One example of the automatic development processor for use in the method of preparing a lithographic printing plate according to the invention is briefly described with reference to Fig. 1.

An automatic development processor 100 shown in Fig.1 comprises a chamber the outer shape of which is formed by a machine casing 202 and has a pre-heating unit 200, a developing unit 300 and a drying unit 400 continuously formed along a transporting direction (arrow A) of a transporting pass 11 for a lithographic printing plate precursor.

The pre-heating unit 200 comprises a heating chamber 208 having a transporting inlet 212 and a transporting outlet 218 and a skewer roller 210, a heater 214 and a circulation fan 216 are arranged in the inside thereof.

The developing unit 300 is separated from the pre-heating unit 200 by an outer panel 310 and a slit type insertion slot 312 is formed in the outer panel 310.

In the inside of the developing unit 300, a processing tank 306 having a developing tank 308 filled with a developer and an insertion roller pair 304 for guiding the lithographic printing plate precursor into the inside of the processing tank 306 are disposed. A shielding cover 324 is located above the developing tank 308.

In the inside of the developing tank 308, a guide roller 344 and a guide member 342, a submerged roller pair 316, a brush roller pair 322, a brush roller pair 326 and a carrying-out roller pair 318 are provided in order from the upstream side of the transporting direction of lithographic printing plate precursor. The lithographic printing plate precursor transported into the developing tank 308 is immersed in the developer and the non-image area is removed by passing between the rotating brush roller pairs 322 and 326.

A spray pipe 330 is provided under the brush roller pairs 322 and 326. The spray pipe 330 is connected to a pump (not shown) and the developer in the developing tank 308 sucked by the pump is ejected from the spray pipe 330 in the developing tank 308.

On a sidewall of the developing tank 308, an overflow aperture 51 is provided to form a top edge of a first circulation pipeline C1. The excess developer flows in the overflow aperture 51, passes through the first circulation pipeline C1 and is discharged in an external tank 50 provided outside the developing unit 300.

To the external tank 50 is connected a second circulation pipeline C2 and a filter unit 54 and a developer supply pump 55 are located in the second circulation pipeline C2. The developer is supplied from external tank 50 to the developing tank 308 by the developer supply pump 55. In the external tank 50, level meters 52 and 53 are provided.

The developing tank 308 is also connected to a water tank for replenishment 71 through a third circulation pipeline C3. A water-replenishing pump 72 is located in the third circulation pipeline C3 and water pooled in the water tank for replenishment 71 is supplied to the developing bath 308 by the water-replenishing pump 72.

A liquid temperature sensor 336 is provided on the upstream side of the submerged roller pair 316. A liquid level meter 338 is provided on the upstream side of the carrying-out roller pair 318.

In a partition board 332 placed between the developing unit 300 and the drying unit 400, a slit type pass-through slot 334 is formed. Also, a shutter (not shown) is provided along a passage between the developing unit 300 and the drying unit 400 and the passage is closed by the shutter when the lithographic printing plate precursor does not pass through the passage.

In the drying unit 400, a support roller 402, ducts 410 and 412, a transport roller pair 406, ducts 410 and 412 and a transport roller pair 408 are disposed in this order. A slit hole 414 is provided at the top of each of the ducts 410 and 412. In the drying unit 400, a drying means (not shown), for example, a hot air supplying means or a heat generating means, is also provided. The drying unit 400 has a discharge slot 404 and the resulting lithographic printing plate dried by the drying means is discharged through the discharge slot 404.

### EXAMPLES

The present invention will be described in more detail with reference to the following examples and comparative examples, but the invention should not be construed as being limited thereto. Hereinafter, with respect to a polymer compound, a ratio of polymerization unit is indicated in a molar ratio and a molecular weight is indicated by a weight average molecular weight.

### Examples 1 to 9 and Comparative Examples 1 to 3

### [Preparation of Lithographic printing plate precursor]

### <Preparation of Support (1)>

An aluminum plate (material: 1050, refining: H16) having a thickness of 0.24 mm was immersed in an aqueous 5% by weight sodium hydroxide solution maintained at 65°C to conduct a degreasing treatment for one minute, followed by washed with water. The degreased aluminum plate was immersed in an aqueous 10% by weight hydrochloric acid solution maintained at 25°C for one minute to neutralize, followed by washed with water. Subsequently, the aluminum plate was subjected to an electrolytic surface-roughening treatment with alternating current under condition of current density of 100 A/dm² in an aqueous 0.3% by weight hydrochloric acid solution at 25°C for 60 seconds and then subjected to a desmut treatment in an aqueous 5% by weight sodium hydroxide solution maintained at 60°C for 10 seconds. The aluminum plate thus-treated was subjected to an anodizing treatment under condition of current density of 10 A/dm² and voltage of 15 V in an aqueous 15% by weight sulfuric acid solution at 25°C for one minute and then subjected to a hydrophilization treatment using an aqueous 1% by weight polyvinylphosphonic acid solution at 75°C to prepare Support (1). The surface roughness of the support was measured and found to be 0.44 µm (Ra indication according to JIS B0601).

### <Formation of Photosensitive layer (1)>

Coating solution (1) for photosensitive layer having the composition shown below was coated on Support (1) using a bar and dried in an oven at 90°C for 60 seconds to form Photosensitive layer (1) having a dry coating amount of 1.3 g/m².

### <Coating solution (1) for photosensitive layer>

| | |
|---|---|
| Binder Polymer (1) shown below (weight average molecular | 0.04g |
| weight: 50,000) | |
| | |
| Binder Polymer (2) shown below (weight average molecular | 0.30 g |
| weight: 80,000) | |
| | |
| Polymerizable Compound (1) shown below | 0.17 g |
| (trade name: PLEX 6661-O, produced by Degussa Japan Co. Ltd.) | |
| Polymerizable Compound (2) shown below | 0.51 g |
| Sensitizing Dye (1) shown below | 0.03 g |
| Sensitizing Dye (2) shown below | 0.015 g |
| Sensitizing Dye (3) shown below | 0.015 g |
| Polymerization Initiator (1) shown below | 0.13 g |
| Chain Transfer Agent | 0.01 g |
| Mercaptobenzothiazole | |
| Dispersion of ε-phthalocyanine pigment | 0.40 g |
| (pigment: 15 parts by weight; dispersing agent (allyl methacrylate/methacrylic acid copolymer (weight average molecular weight: 60,000, copolymerization molar ratio: 83/17)): 10 parts by weight; cyclohexanone: 15 parts by weight) | |
| Thermal polymerization inhibitor | 0.01 g |
| N-Nitrosopbenylhydroxylamine aluminum salt | |
| Fluorine-Based Surfactant (1) shown below (weight average molecular weight: 10,000) | 0.001 g |
| 1-Methoxy-2-propanol | 3.5 g |
| Methyl ethyl ketone | 8.0 g |

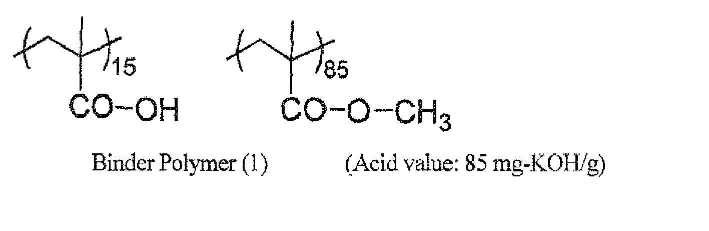

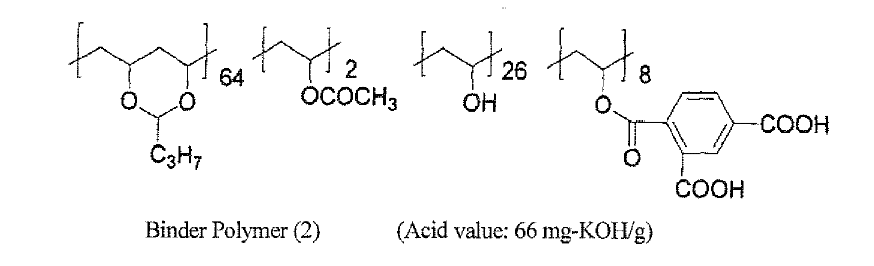

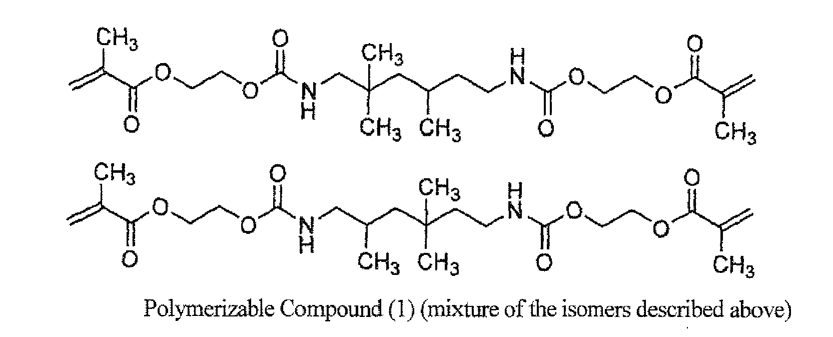

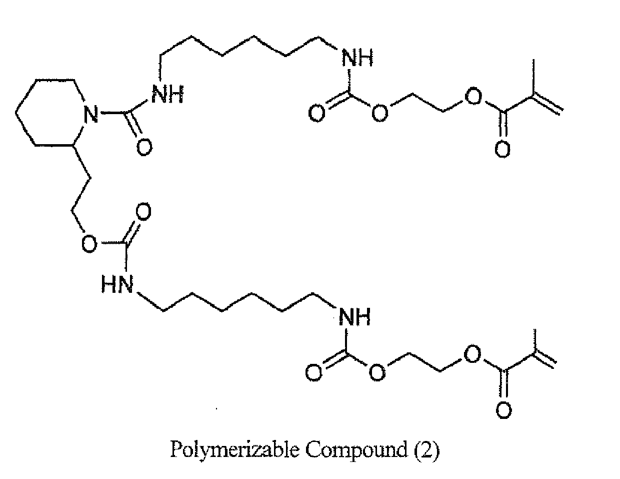

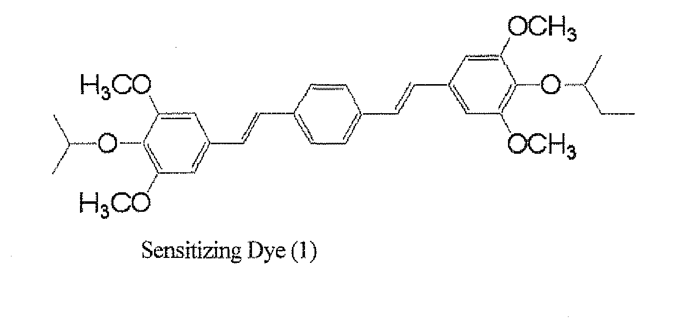

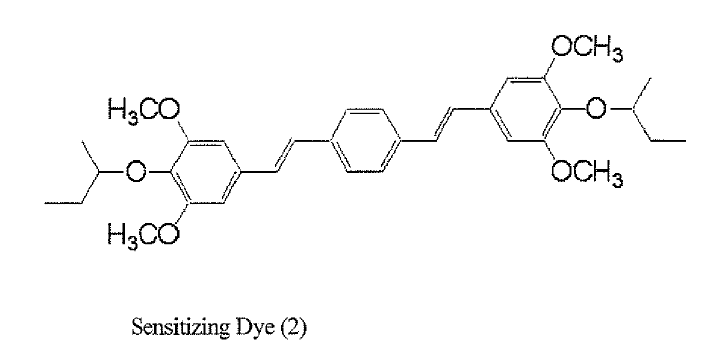

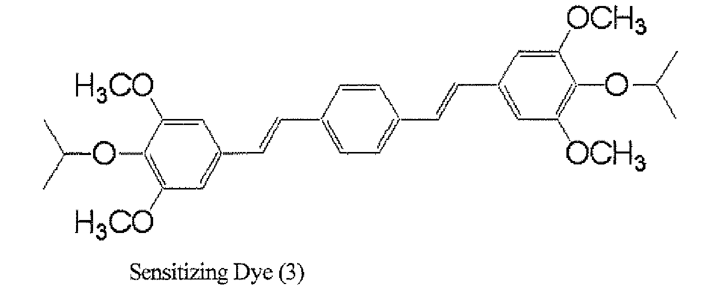

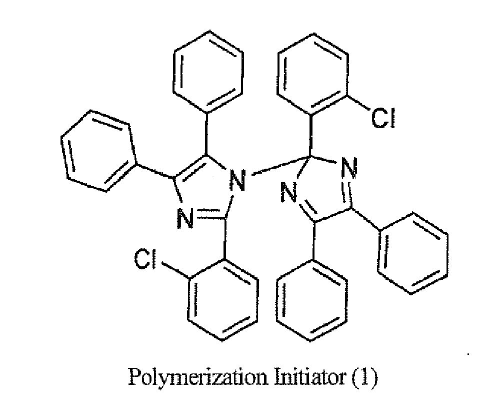

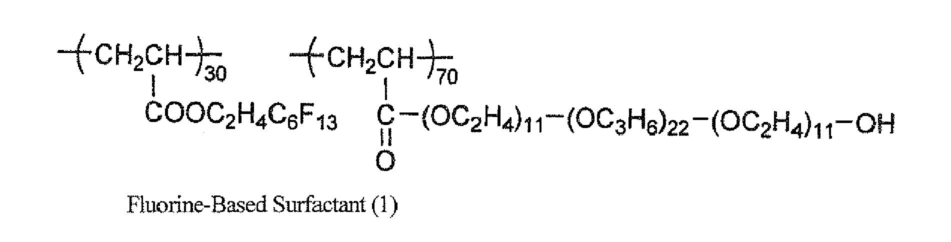

### <Formation of Protective layer>

A composition for protective layer shown in Table 1 below was coated on Photosensitive layer (1) using a bar so as to have a dry coating amount of 1.2 g/m² and dried at 125°C for 70 seconds to from a protective layer, thereby preparing a lithographic printing plate precursor.

**TABLE 1: Composition for Protective Layer (unit: g)**

| Component | Protective | Protective | Protective | Protective | Protective | Protective | Protective | Protective | Protective | Protective | Protective | Protective |
|---|---|---|---|---|---|---|---|---|---|---|---|---|
| | Layer(1) | Layer (2) | Layer (3) | Layer (4) | Layer (5) | Layer (6) | Layer (7) | Layer (8) | Layer (9) | Layer (10) | Layer (11) | Layer (12) |
| PVA-105 | 0.142 | 0.142 | 0.142 | 0.142 | 0.142 | 0.142 | 0.142 | | 0.80 | 0.142 | 0.142 | 0.142 |
| PVA-205 | 0.658 | 0.658 | 0.658 | 0.658 | 0.658 | 0.658 | 0.658 | 0.80 | | 0.658 | 0.658 | 0.658 |
| Poly(vinyl pyrrolidone/vinyl acetate) | 0.001 | 0.001 | 0.001 | 0.001 | 0.001 | 0.001 | 0.001 | 0.001 | 0.001 | 0.001 | 0.001 | 0.001 |
| EMALEX 710 | 0.002 | 0.002 | 0.002 | 0.002 | 0.002 | 0.002 | 0.002 | 0.002 | 0.002 | 0.002 | 0.002 | 0.002 |
| Copolymer A | 0.022 | | | | | 0.010 | 0.080 | 0.022 | 0.022 | | | |
| Copolymer B | | 0.022 | | | | | | | | | | |
| Copolymer C | | | 0.022 | | | | | | | | | |
| Copolymer D | | | | 0.022 | | | | | | | | |
| Copolymer E | | | | | 0.022 | | | | | | | |
| Copolymer F | | | | | | | | | | | 0.022 | |
| KL-506 | | | | | | | | | | | | 0.022 |
| Water | 13 | 13 | 13 | 13 | 13 | 13 | 13 | 13 | 13 | 13 | 13 | 13 |

| | | | | | | | | | | | | |
|---|---|---|---|---|---|---|---|---|---|---|---|---|
| PVA-205: Partially hydrolyzed polyvinyl alcohol, produced by Kuraray Co., Ltd. (saponification degree: 86.5 to 89.5% by mole; viscosity: 4.6 to 5.4 mPa·s in a 4% by weight aqueous solution at 20°C) PVA-105: Fully hydrolyzed polyvinyl alcohol, produced by Kuraray Co., Ltd. (saponification degree: 98.0 to 99.0% by mole; viscosity: 5.2 to 6.0 mPa·s in a 4% by weight aqueous solution at 20°C) Poly(vinyl pyrrolidone/vinyl acetate): Vinyl pyrrolidone/vinyl acetate = 1/1 (in a molar ratio) copolymer (weight average molecular weight: 70,000) EMALEX 710: Surfactant, produced by Nihon Emulsion Co., Ltd. Copolymers A to F: Copolymers having monomer compositions shown in Table 2 below KL-506: Carboxylic acid-modified polyvinyl alcohol, produced by Kuraray Co., Ltd. (saponification degree: 74.0 to 80.0% by mole; viscosity: 5.2 to 6.2 mPa·s in a 4% by weight aqueous solution at 20°C) | | | | | | | | | | | | |

**TABLE 2: Composition of Copolymer (% by mole)**

| Component | Copolymer A | Copolymer B | Copolymer C | Copolymer D | Copolymer E | Copolymer F |
|---|---|---|---|---|---|---|
| Methyl Methacrylate | 60 | 30 | - | - | 40 | 60 |
| N-tert-Butylactylamide | - | - | 40 | 50 | - | - |
| Ethyl Acrylate | 25 | - | - | - | - | 25 |
| Methyl Acrylate | - | 30 | 40 | 30 | 40 | - |
| Sodium p-Styrenesulfonate | - | 30 | 10 | - | - | - |
| Sodium | 15 | - | 10 | 15 | 10 | - |
| 2-Acrylamido-2-methylpropanesulfonate | | | | | | |
| Sodium Vinylsulfonate | - | - | - | 5 | - | - |
| Sodium Methacrylate | - | 10 | - | - | 10 | - |
| N-Isopropylacrylamide | - | - | - | - | - | 15 |
| Weight Average Molecular Weight | 30,000 | 80,000 | 40,000 | 20,000 | 60,000 | 30,000 |

### [Exposure, Development and Printing]

Each of the lithographic printing plate precursors was subjected to image exposure by Violet semiconductor laser plate setter Vx9600 (having InGaN semiconductor laser: emission: 405 mn ± 10 nm/output: 30 mW) produced by FUJIFILM Electronic Imaging, Ltd. The image drawing was conducted with halftone dots of 50% using an FM screen (TAFFETA 20, produced by FUJIFILM Corp.) at resolution of 2,438 dpi and in a plate surface exposure amount of 0.05 mJ/cm².

The exposed lithographic printing plate precursor was then subjected to development processing in an automatic development processor having a structure shown in Fig. 1 using Developer (1) having the composition shown below at transporting speed so as to have pre-heating time of 10 seconds at 100°C and immersion time (developing time) in the developer of 20 seconds.

The lithographic printing plate obtained by the development processing was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G (N) black ink (produced by Dainippon Ink & Chemicals, Inc.).

### <Developer (1)>

| | |
|---|---|
| Water | 88.6 g |
| Nonionic Surfactant (W-1) shown below | 2.4 g |
| | |
| Nonionic Surfactant (W-2) shown below | 2.4 g |
| | |
| Nonionic Surfactant (EMALEX 710, produced | 1.0 g |
| by Nihon Emulsion Co., Ltd.) | |
| | |
| 1-Octanol | 0.6 g |
| N-(2-Hydroxyethyl)morpholine | 1.0 g |
| Triethanolamine | 0.5 g |
| Sodium gluconate | 1.0 g |
| Trisodium citrate | 0.5 g |
| Tetrasodium ethylenediaminetetraacetate | 0.05 g |
| Polystyrenesulfonic acid (trade name: VERSA TL77 (30% by | 1.0 g |
| weight solution), produced by Alco Chemical Inc.) | |

The pH was adjusted to 6.9 by adding phosphoric acid to the developer having the composition described above.

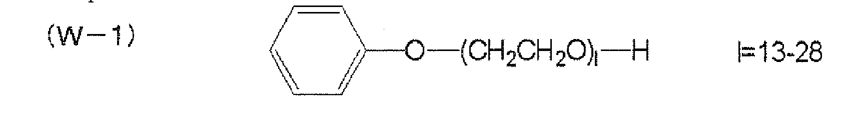

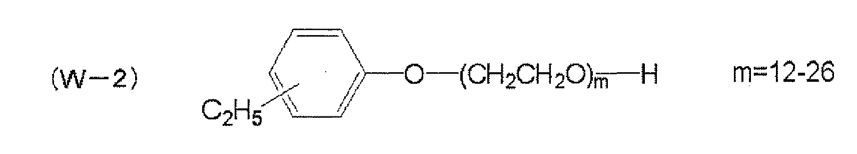

### [Evaluation]

### <Developing property>

The lithographic printing plate precursor was subjected to the image exposure and development processing as described above. After the development processing of 20 m² of lithographic printing plate precursor per one liter of the developer, the non-image area of the lithographic printing plate obtained by the development processing was visually observed and the residue of the photosensitive layer was evaluated according to the criteria described below.
A: Good developing property where the residue of photosensitive layer was not present.
B: No problem in the developing property, although the slight residue of photosensitive layer was present.
C: The photosensitive layer remained to cause development failure.

### <Processing stability (development scum)>

After the development processing of 20 m² of lithographic printing plate precursor per one liter of the developer using the automatic development processor as described above, the generation of scum adhered on the tank wall of the automatic development processor was observed and evaluated according to the criteria described below.
A: The generation of scum was not observed.
B: The generation of scum was observed, but was in an acceptable level.
C: The generation of scum was severe.

### <Printing durability>

As increase in the number of printed materials, the image of the photosensitive layer formed on the lithographic printing plate was gradually abraded to cause decrease in the ink-receptive property, resulting in decrease in ink density of the image on a printing paper. A number of printed materials obtained until the ink density (reflection density) decreased by 0.1 from that at the initiation of printing was determined to evaluate the printing durability. Also, the printing durability in the case where the image exposure was conducted in a plate surface exposure amount of 0.3 mJ/cm² and the pre-heating described above was not conducted in the automatic development processor was evaluated.

**TABLE 3**

| | Photosensitive Layer | Protective Layer | Developing Property | Processing Stability | Printing Durability (with Pre-Heating) | Printing Durability (without Pre-Heating) |
|---|---|---|---|---|---|---|
| Example 1 | (1) | (1) | A | A | 100,000 | 80,000 |
| Example 2 | (1) | (2) | A | B | 100,000 | 80,000 |
| Example 3 | (1) | (3) | A | B | 100,000 | 80,000 |
| Example 4 | (1) | (4) | A | A | 90,000 | 70,000 |
| Example 5 | (1) | (5) | A | B | 100,000 | 80,000 |
| Example 6 | (1) | (6) | A | B | 100,000 | 80,000 |
| Example 7 | (1) | (7) | A | A | 80,000 | 60,000 |
| Example 8 | (1) | (8) | A | A | 70,000 | 60,000 |
| Example 9 | (1) | (9) | B | B | 100,000 | 80,000 |
| Comparative | (1) | (10) | B | C | 100,000 | 80,000 |
| Example 1 | | | | | | |
| Comparative | (1) | (11) | B | C | 100,000 | 80,000 |
| Example 2 | | | | | | |
| Comparative | (1) | (12) | B | C | 100,000 | 80,000 |
| Example 3 | | | | | | |

### Examples 10 to 19 and Comparative Examples 4 to 7

The supports, photosensitive layers and protective layers shown below were combined as shown in Table 5 below to prepare lithographic printing plate precursors, respectively.

### <Preparation of Support>

An aluminum plate having a thickness of 0.3 mm was immersed in an aqueous 10% by weight sodium hydroxide solution at 60°C for 25 seconds to effect etching, washed with running water, neutralized and cleaned with an aqueous 20% by weight nitric acid solution and then washed with water. The aluminum plate was subjected to an electrolytic surface roughening treatment in an aqueous 1 % by weight nitric acid solution using an alternating current with a sinusoidal waveform at an anode time electricity of 300 coulomb/dm². Subsequently, the aluminum plate was immersed in an aqueous 1% by weight sodium hydroxide solution at 40°C for 5 seconds, immersed in an aqueous 30% by weight sulfuric acid solution at 60°C for 40 seconds to effect a desmut treatment, and then subjected to an anodizing treatment in an aqueous 20% by weight sulfuric acid solution for 2 minutes under condition of current density of 2 A/dm² to form an anodic oxide film having a thickness of 2.7 g/m². The surface roughness of the aluminum plate was measured and found to be 0.28 µm (Ra indication according to JIS B0601). The support thus prepared is referred to as Support A.

### <Preparation of Support (2)>

Support A was immersed in a processing solution of 53°C prepared by dissolving 0.4% by weight of polyvinylphosphonic acid (produced by PCAS) in pure water for 10 seconds and the excess processing solution was removed by a nip roll. Then, the aluminum plate was washed with well water having a calcium ion concentration of 150 ppm at 60°C for 4 seconds and further with pure water at 25°C for 4 seconds, followed by removing the excess pure water by a nip roll. Thereafter, the water on the aluminum plate was completely removed in the subsequent drying step thereby preparing Support (2).

### <Preparation of Support (3)>

Undercoat solution (1) shown below was coated on Support A using a bar coater so as to have a dry coating amount of 12 mg/m² and dried at 100°C for 20 seconds to prepare Support (3).

### (Undercoat solution (1))

| | |
|---|---|
| Polymer (SP1) shown below | 0.87 g |
| Polymer (SP2) shown below | 0.73 g |
| Pure water | 1,000.0 g |

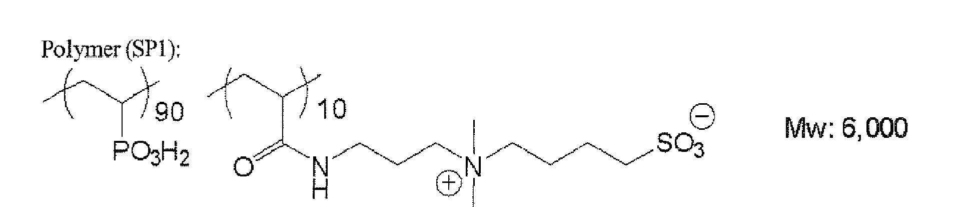

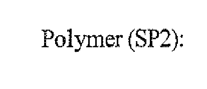

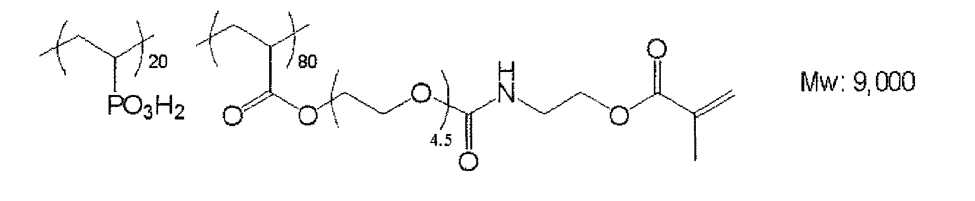

### <Formation of Photosensitive layer (2)>

Coating solution (2) for photosensitive layer having the composition shown below was coated on the support using a bar and dried in an oven at 90°C for 60 seconds to for Photosensitive layer (2) having a dry coating amount of 1.3 g/m².

### (Coating solution (2) for photosensitive layer)

| | | |
|---|---|---|
| Polymerizable Compound (1) shown above | | 3.6 g |
| Binder Polymer (2) shown below (weight average molecular | | 2.4 g |
| weight: 47,000) | | |
| Sensitizing Dye (4) shown below | | 0.32 g |
| Polymerization Initiator (1) shown above | | 0.61 g |
| Chain Transfer Agent (2) shown below | | 0.57 g |
| N-Nitrosophenylhydroxylamine aluminum salt | | 0.020 g |
| Dispersion of ε-phthalocyanine | | 0.71 g |
| | (pigment: 15 parts by weight; dispersing agent (allyl | |
| | methacrylate/methacrylic acid copolymer (weight | |
| | average molecular weight: 60,000, copolymerization | |
| | molar ratio: 83/17)): 10 parts by weight; | |
| | cyclohexanone: 15 parts by weight) | |
| Fluorine-Based Surfactant (1) shown above (weight average | | 0.016 g |
| molecular weight: 10,000) | | |
| Methyl ethyl ketone | | 47 g |
| Propylene glycol monomethyl ether | | 45 g |

The structures of Binder Polymer (2), Chain Transfer Agent (2) and Sensitizing Dye (4) used in Coating solution (2) for photosensitive layer are shown below, respectively.

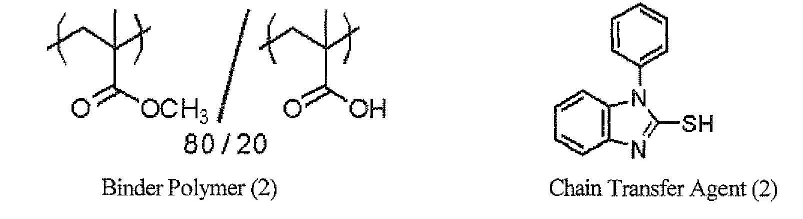

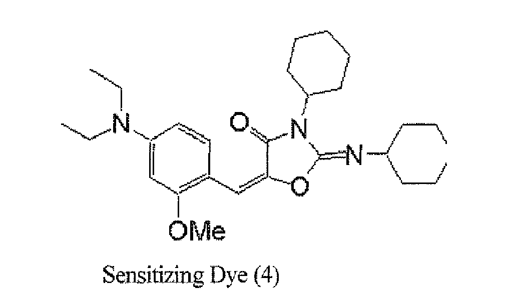

### <Formation of Photosensitive layer (3)>

Coating solution (3) for photosensitive layer having the composition shown below was coated on the support using a bar and dried by a hot air drying device at 125°C for 34 seconds to form Photosensitive layer (3) having a dry coating amount of 1.4 g/m².

### (Coating solution (3) for photosensitive layer)

| | |
|---|---|
| Infrared Absorbing Agent (IR-1) shown below | 0.038 g |
| Polymerization Initiator A (S-1) shown below | 0.061 g |
| Polymerization Initiator B (I-2) shown below | 0.094 g |
| Mercapto Compound (E-1) shown below | 0.015 g |
| Polymerizable Compound (M-2) shown below | 0.629 g |
| (trade name: A-BPE-4, produced by Shin-Nakamura | |
| Chemical Co., Ltd.) | |
| Binder Polymer (B-1) shown above | 0.419 g |
| Additive (T-1) shown below | 0.079 g |
| Polymerization Inhibitor (Q-1) shown below | 0.0012 g |
| Ethyl Violet (EV-1) shown below | 0.021 g |
| Fluorine-Based Surfactant (F-1) shown above | 0.0081 g |
| Methyl ethyl ketone | 5.886 g |
| Methanol | 2.733 g |
| 1-Methoxy-2-propanol | 5.886 g |

The structures of Infrared Absorbing Agent (IR-1), Polymerization Initiator A (S-1), Polymerization Initiator B (I-2), Mercapto Compound (E-1), Polymerizable Compound (M-2), Additive (T-1), Polymerization Inhibitor (Q-1) and Ethyl Violet (EV-1) used in Coating solution (3) for photosensitive layer are shown below, respectively.

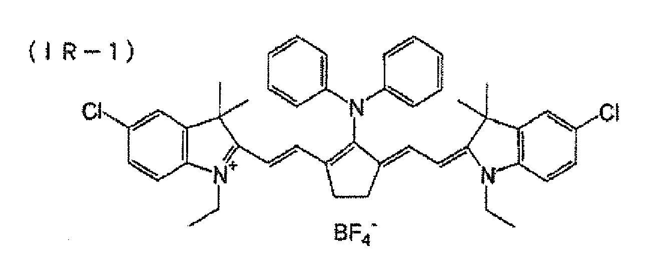

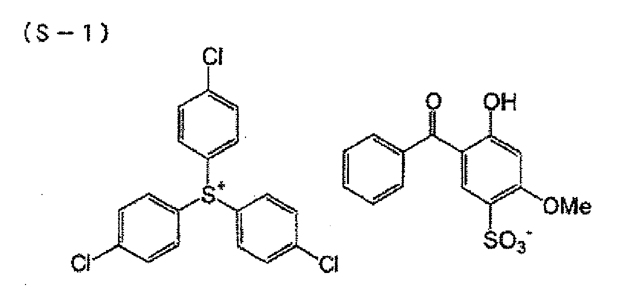

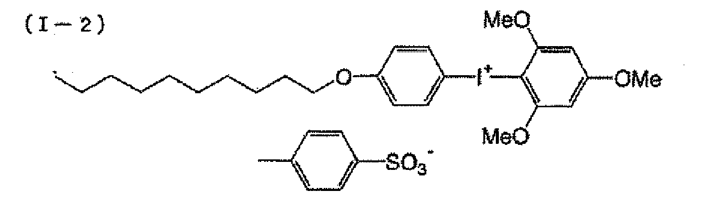

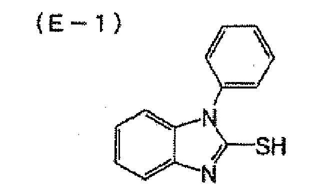

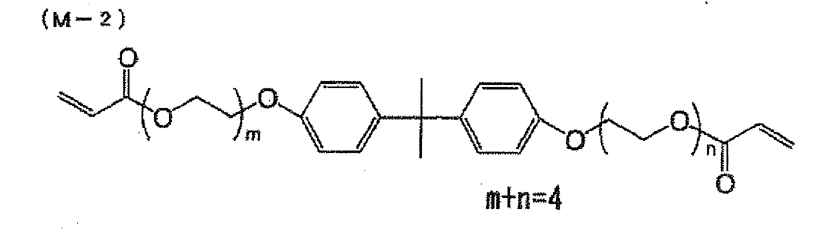

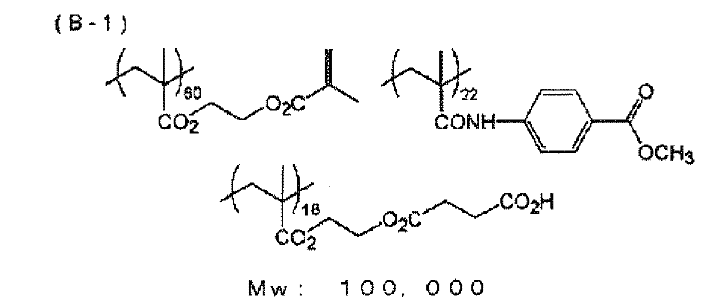

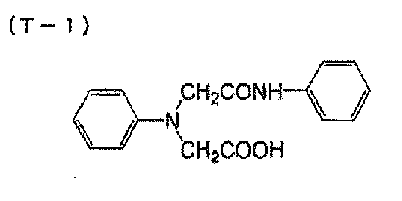

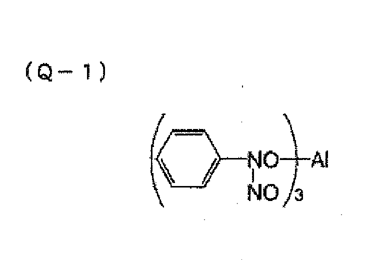

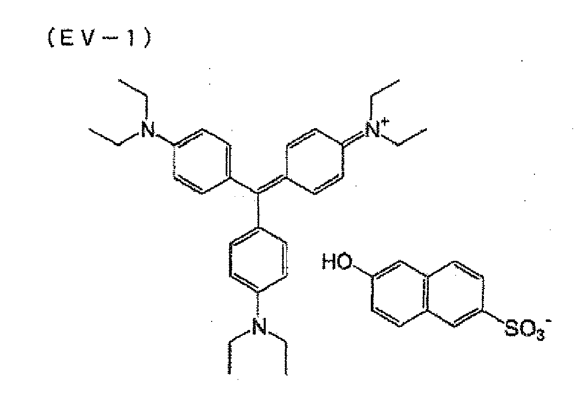

### <Formation of Protective layer>

A composition for protective layer shown in Table 4 below was coated on Photosensitive layer (2) or (3) using a bar so as to have a dry coating amount of 1.2 g/m² and dried at 125°C for 70 seconds to from a protective layer, thereby preparing a lithographic printing plate precursor.

**TABLE 4: Composition for Protective Layer (unit: g)**

| Component | Protective Layer (13) | Protective Layer (14) | Protective Layer (15) | Protective Layer (16) | Protective Layer (17) | Protective Layer (18) | Protective Layer (19) | Protective Layer (20) | Protective Layer (21) | Protective Layer (22) | Protective Layer (23) |
|---|---|---|---|---|---|---|---|---|---|---|---|
| Sulfonic Acid-Modified Polyvinyl Alcohol | 0.8 | 0.8 | 0.8 | 0.8 | 0.8 | 0.8 | 0.8 | 0.8 | 0.142 | 0.142 | 0.142 |
| Dispersion of Mica | 0.6 | 0.6 | 0.6 | 0.6 | 0.6 | 0.6 | 0.6 | | 0.658 | 0.658 | 0.658 |
| EMALEX 710 | 0.002 | 0.002 | 0.002 | 0.002 | 0.002 | 0.002 | 0.002 | 0.002 | 0.002 | 0.002 | 0.002 |
| Copolymer A | 0.022 | | | | | 0.010 | 0.080 | 0.022 | | | |
| Copolymer B | | 0.022 | | | | | | | | | |
| Copolymer C | | | 0.022 | | | | | | | | |
| Copolymer D | | | | 0.022 | | | | | | | |
| Copolymer E | | | | | 0.022 | | | | | | |
| Copolymer F | | | | | | | | | | 0.022 | |
| KL-506 | | | | | | | | | | | 0.022 |
| Water | 13 | 13 | 13 | 13 | 13 | 13 | 13 | 13 | 13 | 13 | 13 |

Sulfonic Acid-Modified Polyvinyl Alcohol: GOSERAN CKS-50, produced by Nippon Synthetic Chemical Industry Co., Ltd. (saponification degree: 99% by mole; average polymerization degree: 300; modification degree: about 0.4% by mole)
Dispersion of Mica: Dispersion of mica obtained by adding 32 g of synthetic mica (SOMASIF ME-100, produced by CO-OP Chemical Co., Ltd.; aspect ratio: 1,000 or more) to 368 g of water and dispersing the mixture using a homogenizer until the average particle diameter (measured by a laser scattering method) became 0.5 µm.
EMALEX 710: Surfactant, produced by Nihon Emulsion Co., Ltd.
Copolymers A to F: Copolymers having the compositions shown in Table 2 above
KL-506: Carboxylic acid-modified polyvinyl alcohol, produced by Kuraray Co., Ltd.
(saponification degree: 74.0 to 80.0% by mole; viscosity: 5.2 to 6.2 mPa·s in a 4% by weight aqueous solution at 20°C)

### <Developer (2)>

| | |
|---|---|
| Surfactant-1 shown below (SOFTAZOLINE LPB-R, | 15 g |
| produced by Kawaken Fine Chemicals Co., Ltd.) | |
| | |
| Surfactant-2 shown below (SOFTAZOLINE LAO, | 4 g |
| Produced by Kawaken Fine Chemicals Co., Ltd.) | |
| | |
| Chelating agent: Trisodium ethylenediaminesuccinate (OCTAQUEST E30, | 0.68 g |
| produced by Innospec Specialty Chemicals Inc.) | |
| | |
| 2-Bromo-2-nitropropane-1,3-diol | 0.025 g |
| | |
| 2-Methyl-4-isotiazoline-3-one | 0.025 g |
| | |
| Silicone type reforming agent: (TSA 739, produced by GE Toshiba Silicone | 0.15 g |
| Co., Ltd.) | |
| | |
| Sodium gluconate | 1.5 g |
| | |
| Sodium carbonate | 1.06 g |
| | |
| Sodium hydrogen carbonate | 0.52 g |
| | |
| Water | 77.04 g |

The pH was adjusted to 9.8 by adding sodium hydroxide and phosphoric acid to the developer having the composition described above.

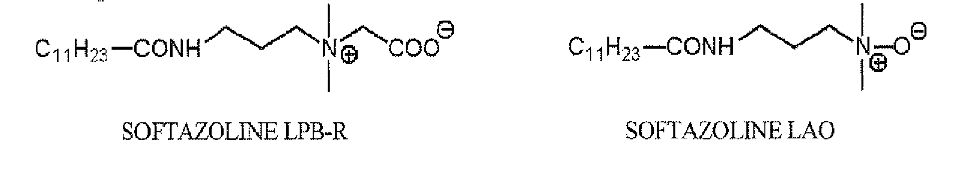

### [Evaluation]

### <Lithographic printing plate precursor having Photosensitive layer (2)>

The exposure and development processing of the lithographic printing plate precursor were conducted in the same manner as in Examples 1 to 9 except for using Developer (2) in place of Developer (1). Further, the printing was conducted in the same manner as in Examples 1 to 9 and the evaluation was conducted in the same manner as in Examples 1 to 9.

### <Lithographic printing plate precursor having Photosensitive layer (3)>

The image exposure was conducted by Trendsetter 3244VX (produced by Creo Co.) equipped with a water-cooled 40 W infrared semiconductor laser under the conditions of output of 9 W, a rotation number of an external drum of 210 rpm and resolution of 2,400 dpi. As an exposure pattern, square dot of 50% was used.

With respect to the development processing and printing, the development processing of the lithographic printing plate precursor was conducted in the same manner as in Examples 1 to 9 except for using Developer (2) in place of Developer (1) and the printing was conducted in the same manner as in Examples 1 to 9. The evaluation was conducted in the same manner as in Examples 1 to 9. In the evaluation without pre-heating, the exposure same as in the evaluation with pre-heating was conducted.

**TABLE 5**

| | Support | Photosensitive Layer | Protective Layer | Developing Property | Processing Stability | Printing Durability (with Pre-Heating) | Printing Durability (without Pre-Heating) |
|---|---|---|---|---|---|---|---|
| Example 10 | (2) | (2) | (13) | A | A | 100,000 | 80,000 |
| Example 11 | (2) | (2) | (14) | A | B | 100,000 | 80,000 |
| Example 12 | (2) | (2) | (15) | A | A | 100,000 | 80,000 |
| Example 13 | (2) | (2) | (16) | A | A | 90,000 | 70,000 |
| Example 14 | (2) | (2) | (17) | A | B | 100,000 | 80,000 |
| Example 15 | (2) | (2) | (18) | A | B | 100,000 | 80,000 |
| Example 16 | (2) | (2) | (19) | A | A | 80,000 | 60,000 |
| Example 17 | (2) | (2) | (20) | A | A | 80,000 | 60,000 |
| Example 18 | (3) | (2) | (13) | A | A | 100,000 | 80,000 |
| Example 19 | (3) | (3) | (13) | A | A | 100,000 | 90,000 |
| Comparative | (2) | (2) | (21) | B | C | 100,000 | 80,000 |
| Example 4 | | | | | | | |
| Comparative | (3) | (3) | (21) | B | C | 100,000 | 90,000 |
| Example 5 | | | | | | | |
| Comparative | (2) | (2) | (22) | B | C | 100,000 | 90,000 |
| Example 6 | | | | | | | |
| Comparative | (2) | (2) | (23) | B | C | 100,000 | 90,000 |
| Example 7 | | | | | | | |

### Examples 20 to 23

### <Formation of Photosensitive layer (4)>

Coating solution (4) for photosensitive layer having the composition shown below was coated on Support (2) so as to have a dry coating amount of 1.4 g/m² and dried at 100°C for one minute to form Photosensitive layer (4).

### <Coating solution (4) for photosensitive layer>

| | | |
|---|---|---|
| Polymerizable Compound (1) shown above | | 4.0 parts by weight |
| | | |
| Binder polymer (Binder B shown below) (weight average molecular | | 2.0 parts by |
| weight: 35,000) | | weight |
| | | |
| Sensitizing Dye (4) shown above | | 0.32 parts by |
| | | weight |
| | | |
| Polymerization Initiator (1) shown above | | 0.61 parts by |
| | | weight |
| | | |
| Sodium gluconate | | 0.10 parts by |
| | | weight |
| | | |
| Chain Transfer Agent (2) shown above | | 0.57 parts by |
| | | weight |
| N-Nitrosophenylhydroxylamine aluminum salt | | 0.020 parts |
| | | by weight |
| Dispersion of ε-phthalocyanine pigment | | 0.71 parts by |
| | | weight |
| | | |
| | (pigment: 15% by weight; dispersing agent (allyl methacrylate/methacrylic acid copolymer (weight average molecular weight: 60,000, copolymerization molar ratio: 80/20)): 10% by weight; solvent (cyclohexanone/methoxypropyl acetate/1-methoxy-2-propanol = 15% by weight/20% by weight/40% by weight)) | |
| | | |
| Fluorine-based nonionic surfactant (MEGAFAC F780, produced by | | 0.016 parts |
| Dainippon Ink & Chemicals, Inc.)) | | by weight |
| | | |
| Methyl ethyl ketone | | 47 parts by |
| | | weight |
| | | |
| Propylene glycol monomethyl ether | | 45 parts by |
| | | weight |

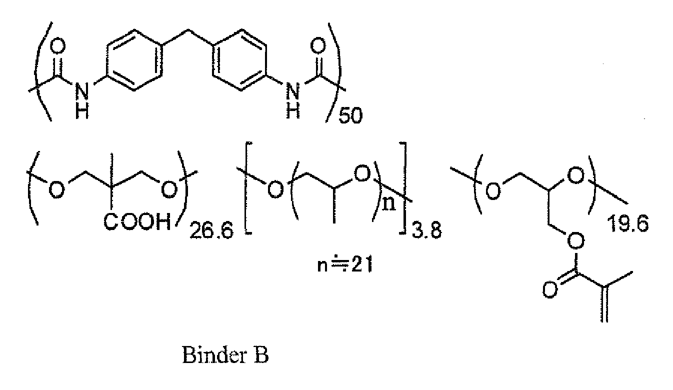

### <Composition of Developer>

### <Developer (3)>

| | |
|---|---|
| NEWCOL B-13 (produced by Nippon Nyukazai Co., Ltd.) | 3g |
| Chelating agent: Trisodium ethylenediaminesuccinate (OCTAQUEST E30, produced by Innospec Specialty Chemicals Inc.) | 0.68 g |
| 2-Bromo-2-nitropropane-1,3-diol | 0.025 g |
| 2-Methyl-4-isothiazoline-3-one | 0.025 g |
| Silicone type deforming agent: (TSA 739, produced by GE Toshiba | 0.15 g |
| Silicone Co., Ltd.) | |
| Sodium gluconate | 1.5 g |
| Sodium carbonate | 1.06 g |
| Sodium hydrogen carbonate | 0.52 g |
| Water | 77.04 g |
| (pH: 9.8) | |

### <Developer (4)>

Developer (4) was prepared by adding the material shown below to Developer (3).

| | |
|---|---|
| Enzyme (NS44126, produced by Novozymes Japan Ltd., 7.5% aqueous solution) | 0.3 g |
| (pH: 9.8) | |

### <Developer (5)>

| | |
|---|---|
| Propylene oxide-ethylene oxide block copolymer | 20.0 g |
| (PE 9400, produced by BASF AG) | |
| Surfactant (EMULSOGEN TS 160, produced by Clariant AG) | 0.30 g |
| Sodium gluconate | 0.75 g |
| 85% Aqueous phosphoric acid solution | 5.88 g |
| Triethanolamine | 14.5 g |
| Water | 73.07 g |
| (pH: 7.0) | |

### <Developer (6)>

Developer (6) was prepared by adding the material shown below to Developer (5).

| | |
|---|---|
| Enzyme (NS44126, produced by Novozymes Japan Ltd., 7.5% aqueous solution) | 0.3 g |
| (pH: 7.0) | |

The supports, photosensitive layers and protective layers were combined as shown in Table 6 below to prepare lithographic printing plate precursors, respectively. The lithographic printing plate precursors were subjected to the exposure and development processing in the same manner as in Examples 1 to 9 except for using the developers shown in Table 6, respectively. Further, the printing was conducted in the same manner as in Examples 1 to 9 and the evaluation was conducted in the same manner as in Examples 1 to 9. In the evaluation without pre-heating, the exposure same as in the evaluation with pre-heating was conducted.

**TABLE 6**

| | Support | Photosensitive Layer | Protective Layer | Developer | Developing Property | Processing Stability | Printing Durability (with Pre-Heating) | Printing Durability (without Pre-Heating) |
|---|---|---|---|---|---|---|---|---|
| Example 20 | (2) | (4) | (13) | (3) | A | A | 170,000 | 100,000 |
| Example 21 | (2) | (4) | (13) | (4) | A | B | 170,000 | 100,000 |
| Example 22 | (1) | (1) | (1) | (5) | A | A | 100,000 | 80,000 |
| Example 23 | (1) | (1) | (1) | (6) | A | B | 100,000 | 80,000 |

As is apparent from the results shown in Tables 3, 5 and 6, the method of preparing a lithographic printing plate according to the invention maintains the good developing property and prevents the occurrence of development scum to provide satisfactory results.

## Claims

1. A method of preparing a lithographic printing plate, comprising:
exposing with laser a lithographic printing plate precursor comprising, in the following order, (i) a hydrophilic support, (ii) a photosensitive layer containing (A) a polymerization initiator, (B) a polymerizable compound, (C) a sensitizing dye and (D) a binder polymer and (iii) a protective layer containing (E) a polymer which has a repeating unit represented by the following formula (I) and in which a ratio of a repeating unit having a hydroxy group to total repeating units is 70% by mole or less; and
removing the protective layer and an unexposed area of the photosensitive layer of the exposed lithographic printing plate precursor at the same time in the presence of a developer containing a surfactant,
wherein the method is free from a water washing step: 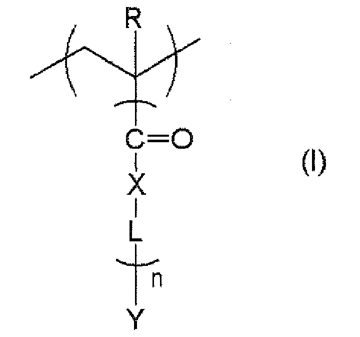 wherein R represents a hydrogen atom or an alkyl group which may have a substituent, X represents an oxygen atom, a sulfur atom or -NR₁-, R₁ represents a hydrogen atom or an alkyl group which may have a substituent, L represents a single bond or a connecting group, Y represents -SO₃M, -PO₃M₂ or -COOM, M each independently represents a hydrogen atom, an alkali metal atom or an onium group, and n represents an integer of 0 or more.

2. The method of preparing a lithographic printing plate as claimed in Claim 1, wherein the developer has a pH of from 2.0 to 10.9.

3. The method of preparing a lithographic printing plate as claimed in Claim 1 or 2, wherein the developer contains a pH buffer agent.

4. The method of preparing a lithographic printing plate as claimed in Claim 3, wherein the pH buffer agent contains a carbonate and a hydrogen carbonate.

5. The method of preparing a lithographic printing plate as claimed in Claim 3, wherein the pH buffer agent contains a water-soluble organic amine compound and an ion of the amine compound.

6. The method of preparing a lithographic printing plate as claimed in any one of Claims 1 to 5, wherein the developer contains a water-soluble polymer compound.

7. The method of preparing a lithographic printing plate as claimed in any one of Claims 1 to 6, wherein Y in the formula (I) is SO₃M.

8. The method of preparing a lithographic printing plate as claimed in any one of Claims 1 to 7, the protective layer further contains a water-soluble polymer compound which is different from the polymer which has a repeating unit represented by formula (I).

9. The method of preparing a lithographic printing plate as claimed in Claim 8, wherein the water-soluble polymer compound is polyvinyl alcohol.

10. The method of preparing a lithographic printing plate as claimed in Claim 9, wherein the polyvinyl alcohol comprises at least two polyvinyl alcohols having saponification degrees different from each other.

11. The method of preparing a lithographic printing plate as claimed in any one of Claims 1 to 10, the protective layer further contains an inorganic stratiform compound.
